# EUROPEAN PATENT APPLICATION

(11) **EP 4 629 806 A1**
(43) Date of publication of application: **08.10.2025**
(21) Application number: 25168255.5
(22) Date of filing: 03.04.2025
(51) Int. Cl.: H10K 59/131

(54) **DISPLAY DEVICE**

(30) Priority: 03.04.2024 KR 20240045206
(71) Applicant: Samsung Display Co., Ltd., Yongin-si, Gyeonggi-do 17113 (KR)
(72) Inventor: Cho, Young Jin, Yongin-si, Gyeonggi-do (KR); Moon, Joong Soo, Yongin-si, Gyeonggi-do (KR); Lee, Min Ku, Yongin-si, Gyeonggi-do (KR); Lee, Seung Hee, Yongin-si, Gyeonggi-do (KR); Jo, Eun Byul, Yongin-si, Gyeonggi-do (KR)
(74) Representative: Gulde & Partner

(57) **Abstract**

A display device includes: a pad area in a non-display area of a substrate; a first cluster pad and a second cluster pad in a pad area; and routing lines on the substrate and electrically connected from the display area to the first cluster pad and the second cluster pad, wherein the routing lines include a first routing line extending to the first cluster pad and a second routing line extending to the second cluster pad, the first routing line and the second routing line are adjacent, the first routing line includes a first middle portion extending in a second direction crossing a first direction that is a horizontal direction, and the second routing line includes a second middle portion adjacent to and parallel to the first middle portion, and the first middle portion and the second middle portion are between the first cluster pad and the second cluster pad.

## Description

### BACKGROUND

### 1. Field

Aspects of some embodiments of the present disclosure relate to a display device.

### 2. Description of the Related Art

As the information society develops, consumer demand for display devices for displaying images has increased and diversified. For example, display devices have been applied to various electronic devices such as smartphones, digital cameras, laptop computers, navigation devices, and smart televisions.

Recently, in the display device, in order to widen a display area where pixels displaying images are located, a bezel area or a non-display area excluding the display area has been relatively reduced. Various signal lines may be located in the bezel area or the non-display area, but a resistance difference between the signal lines may occur depending on lengths and widths of the signal lines, which may deteriorate or reduce display quality.

The above information disclosed in this Background section is only for enhancement of understanding of the background and therefore the information discussed in this Background section does not necessarily constitute prior art.

### SUMMARY

Aspects of some embodiments of the present disclosure include a display devicecapable of relatively improving display quality by reducing a resistance difference between lines in a non-display area.

However, aspects of embodiments according to the present disclosure are not restricted to those set forth herein. The above and other aspects of embodiments according to the present disclosure will become more apparent to one of ordinary skill in the art to which the present disclosure pertains by referencing the detailed description of the present disclosure given below.

According to some embodiments of the present disclosure, a display device includes a substrate including a display area and a non-display area, a pad area in the non-display area of the substrate, a first cluster pad and a second cluster pad in the pad area, and routing lines on the substrate and electrically connected from the display area to the first cluster pad and the second cluster pad, wherein the routing lines include a first routing line extending to the first cluster pad and a second routing line extending to the second cluster pad, the first routing line and the second routing line are adjacent to each other, the first routing line includes a first middle portion extending in a second direction crossing a first direction that is a horizontal direction, and the second routing line includes a second middle portion adjacent to and parallel to the first middle portion, and the first middle portion and the second middle portion are between the first cluster pad and the second cluster pad.

According to some embodiments, the first routing line includes a first front end portion extending from the display area, a first connection portion bent and extending from the first front end portion, a first extension portion bent and extending from the first middle portion, and a first rear end portion bent from the first extension portion and extending to the first cluster pad, and the first middle portion is bent and extends from the first connection portion.

According to some embodiments, the first front end portion, the first middle portion, and the first rear end portion extend in the second direction and are parallel to each other.

According to some embodiments, the display device further comprises a power line on the non-display area, extending in the first direction, and overlapping the routing lines.

According to some embodiments, the first front end portion and the first middle portion do not overlap the power line, and the first connection portion overlaps the power line.

According to some embodiments, the second routing line includes a second front end portion extending from the display area, a second connection portion bent and extending from the second front end portion, a second extension portion bent and extending from the second middle portion, and a second rear end portion bent from the second extension portion and extending to the second cluster pad, and the second middle portion is bent and extends from the second connection portion.

According to some embodiments, the second front end portion, the second middle portion, and the second rear end portion extend in the second direction and are parallel to each other, and the first front end portion and the second front end portion, the first middle portion and the second middle portion, and the first rear end portion and the second rear end portion are parallel to each other, respectively.

According to some embodiments, the display device further comprises a power line on the non-display area, extending in the first direction, and overlapping the routing lines, wherein the second front end portion and the second middle portion do not overlap the power line, and the second connection portion overlaps the power line.

In the area where each of the first routing lines and the second routing lines overlaps the power line, intervals between the respective routing lines may be the same.

According to some embodiments, the first routing line further includes a first front end bent portion between the first front end portion and the first connection portion, a first middle bent portion between the first connection portion and the first middle portion, a first extension bent portion between the first middle portion and the first extension portion, and a first rear end bent portion between the first extension portion and the first rear end portion.

According to some embodiments, the second routing line further includes a second front end bent portion between the second front end portion and the second connection portion, a second middle bent portion between the second connection portion and the second middle portion, a second extension bent portion between the second middle portion and the second extension portion, and a second rear end bent portion between the second extension portion and the second rear end portion.

According to some embodiments, an interval between the first front end portion and the second front end portion is greater than an interval between the first middle portion and the second middle portion, and an interval between the first rear end portion and the second rear end portion is greater than the interval between the first front end portion and the second front end portion.

According to some embodiments, the display device further comprises another first routing line adjacent to the first routing line, wherein an interval between the first front end portions of the first routing lines adjacent to each other is greater than an interval between the first middle portions of the first routing lines adjacent to each other, and the interval between the first middle portions of the first routing lines adjacent to each other is greater than an interval between the first rear end portions of the first routing lines adjacent to each other.

According to some embodiments, the display device further comprises another second routing line adjacent to the second routing line, wherein an interval between the second front end portions of the second routing lines adjacent to each other is greater than an interval between the second middle portions of the second routing lines adjacent to each other, and the interval between the second middle portions of the second routing lines adjacent to each other is greater than an interval between the second rear end portions of the second routing lines adjacent to each other.

According to some embodiments, widths and lengths of the routing lines are the same as each other, respectively.

According to some embodiments of the present disclosure, a display device includes a display panel, a plurality of pixels in a display area of the display panel, a pad area in a non-display area of the display panel and including a first cluster pad and a second cluster pad, data routing lines extending from the display area to the pad area, and a power line in the non-display area and crossing the data routing lines, wherein the data routing lines include first data routing lines extending to the first cluster pad and second data routing lines extending to the second cluster pad, and the first data routing lines and the second data routing lines each include four bent portions in a plan view.

According to some embodiments, each of the first data routing lines includes a first front end portion extending from the display area, a first connection portion bent and extending from the first front end portion, a first middle portion bent and extending from the first connection portion, a first extension portion bent and extending from the first middle portion, and a first rear end portion bent from the first extension portion and extending to the first cluster pad, and each of the second data routing lines includes a second front end portion extending from the display area, a second connection portion bent and extending from the second front end portion, a second middle portion bent and extending from the second connection portion, a second extension portion bent and extending from the second middle portion, and a second rear end portion bent from the second extension portion and extending to the second cluster pad.

According to some embodiments, each of the first data routing lines further includes a first front end bent portion between the first front end portion and the first connection portion, a first middle bent portion between the first connection portion and the first middle portion, a first extension bent portion between the first middle portion and the first extension portion, and a first rear end bent portion between the first extension portion and the first rear end portion, and each of the second data routing lines further includes a second front end bent portion between the second front end portion and the second connection portion, a second middle bent portion between the second connection portion and the second middle portion, a second extension bent portion between the second middle portion and the second extension portion, and a second rear end bent portion between the second extension portion and the second rear end portion.

According to some embodiments, in the first data routing line and the second data routing line adjacent to each other among the first data routing lines and the second data routing lines, the first front end bent portion and the first rear end bent portion of the first data routing line overlap the first cluster pad in a second direction crossing a first direction that is a horizontal direction in a plan view.

According to some embodiments, the first middle bent portion and the first extension bent portion of the first data routing line and the second middle bent portion and the second extension bent portion of the second data routing line overlap an area between the first cluster pad and the second cluster pad in the second direction in a plan view.

According to some embodiments, widths and lengths of the first data routing lines and the second data routing lines are the same as each other, respectively.

According to some embodiments of the present disclosure, a display device comprises a substrate including a non-display area including a pad area, and a display area, a first cluster pad and a second cluster pad on the pad area of the substrate, first data routing lines on the non-display area of the substrate and extending from the display area to the first cluster pad, second data routing lines on the non-display area of the substrate and extending from the display area to the second cluster pad, and a first insulating layer on the non-display area of the substrate, wherein the first data routing lines include a first-first routing line beneath the first insulating layer and a first-second routing line on the first insulating layer, the second data routing lines include a second-first routing line beneath the first insulating layer and a second-second routing line on the first insulating layer, and the first-second routing line and the second-first routing line are adjacent to each other, and each include four bent portions in a plan view.

According to some embodiments, the first-first routing lines and the first-second routing lines are alternately and repeatedly arranged with the first insulating layer interposed therebetween, and the second-first routing lines and the second-second routing lines are alternately and repeatedly arranged with the first insulating layer interposed therebetween.

According to some embodiments, the display device further comprises a voltage line on the first-second routing line and the second-first routing line, wherein the first data routing lines and the second data routing lines overlap the voltage line.

According to some embodiments, widths and lengths of the first data routing lines and the second data routing lines are the same as each other, respectively.

According to some embodiments of the present disclosure, an electronic device, comprises a display device configured to provide an image, a display device configured to provide an image, a processor configured to provide an image data signal to the display device, a memory configured to store a data information for operation, and a power moduel configured to generate power,, wherein the display device comprises, a substrate including a display area and a non-display area, a pad area in the non-display area of the substrate, a first cluster pad and a second cluster pad in the pad area, and routing lines on the substrate and electrically connected from the display area to the first cluster pad and the second cluster pad, wherein the routing lines include a first routing line extending to the first cluster pad and a second routing line extending to the second cluster pad, the first routing line and the second routing line are adjacent to each other, the first routing line includes a first middle portion extending in a second direction crossing a first direction that is a horizontal direction, and the second routing line includes a second middle portion adjacent to and parallel to the first middle portion, and the first middle portion and the second middle portion are between the first cluster pad and the second cluster pad.

A display device according to some embodiments may prevent or reduce RC delay by making line resistances of routing lines the same as each other by adjusting extension shapes of the routing lines in order to make widths and lengths of the routing lines the same as each other. Accordingly, it may be possible to relatively improve display quality by relatively improving a luminance difference of the display device.

The characteristics of embodiments according to the present disclosure are not limited to the aforementioned effects, and various other characteristics are included in the present specification.

### BRIEF DESCRIPTION OF THE DRAWINGS

The above and other aspects and features of embodiments according to the present disclosure will become more apparent by describing in more detail aspects of some embodiments thereof with reference to the attached drawings, in which:
FIG. 1 is a perspective view illustrating a display device according to an embodiment;
FIG. 2 is a plan view illustrating the display device according to an embodiment;
FIG. 3 is a plan view illustrating a display panel of FIG. 2;
FIG. 4 is a circuit diagram of a pixel of the display device according to an embodiment;
FIG. 5 is a cross-sectional view illustrating the display device according to an embodiment;
FIG. 6 is a plan view illustrating a non-display area of the display device according to an embodiment;
FIG. 7 is an enlarged plan view illustrating further details of the area A of FIG. 6;
FIG. 8 is a schematic plan view illustrating a first routing line according to an embodiment;
FIG. 9 is a schematic plan view illustrating a second routing line according to an embodiment;
FIG. 10 is a cross-sectional view taken along the line Q1-Q1' in FIG. 7;
FIG. 11 is an enlarged plan view illustrating further details of the area B of FIG. 7 according to an embodiment; and
FIG. 12 is a cross-sectional view taken along the lines Q2-Q2', Q3-Q3', and Q4-Q4' of FIG. 7.
FIG. 13 is a block diagram of an electronic device according to one embodiment of the present disclosure.
FIG. 14 is a schematic diagram of an electronic device according to various embodiments of the present disclosure.

### DETAILED DESCRIPTION

Aspects of an embodiment of the present invention will now be described more fully hereinafter with reference to the accompanying drawings, in which aspects of some embodiments of the present disclosure are shown. This invention may, however, be embodied in different forms and should not be construed as limited to the embodiments set forth herein. Rather, these embodiments are provided so that this disclosure will be more thorough and more complete, and will more fully convey the scope of embodiments according to the present disclosure to those skilled in the art.

It will also be understood that when a layer is referred to as being "on" another layer or substrate, it can be directly on the other layer or substrate, or intervening layers may also be present. The same reference numbers indicate the same components throughout the specification.

It will be understood that, although the terms "first," "second," etc. may be used herein to describe various elements, these elements should not be limited by these terms. These terms are only used to distinguish one element from another element. For instance, a first element discussed below could be termed a second element without departing from the teachings of the present invention. Similarly, the second element could also be termed the first element.

Each of the features of the various embodiments of the present disclosure may be combined or combined with each other, in part or in whole, and technically various interlocking and driving are possible. Each embodiment may be implemented independently of each other or may be implemented together in an association.

Hereinafter, aspects of some embodiments will be described in more detail with reference to the accompanying drawings.

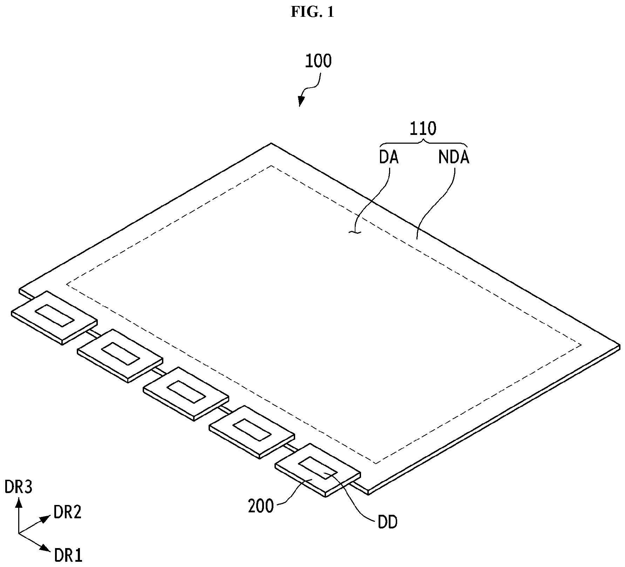

FIG. 1 is a perspective view illustrating a display device according to some embodiments.

Referring to FIG. 1, a display device 100 is a device that displays moving images (e.g., video images) or still images (e.g., static images), and may be used as a display screen of various products such as televisions, laptop computers, monitors, billboards, and the Internet of Things (IOT) as well as portable electronic devices such as mobile phones, smartphones, tablet personal computers (PCs), smart watches, watch phones, mobile communication terminals, electronic notebooks, electronic books, portable multimedia players (PMPs), navigation devices, and ultra mobile PCs (UMPCs).

The display device 100 may be a light emitting display device such as an organic light emitting display device using organic light emitting diodes, a quantum dot light emitting display device including quantum dot light emitting layers, an inorganic light emitting display device including inorganic semiconductors, and a micro light emitting display device using micro or nano light emitting diodes (micro LEDs or nano LEDs). Hereinafter, it will be mainly described that the display device 100 is the organic light emitting display device, but embodiments according to the present disclosure are not limited thereto.

The display device 100 may include a display panel 110 and circuit boards 200.

The display panel 110 may be formed in a rectangular shape, in a plan view, having long sides in a first direction DR1 and short sides in a second direction DR2 crossing the first direction DR1. A corner where the long side in the first direction DR1 and the short side in the second direction DR2 meet may be rounded with a curvature (e.g., a set or predetermined curvature) or may be right-angled.

A shape of the display panel 110 in a plan view is not limited to the rectangular shape, and may be other polygonal shapes, a circular shape, or an elliptical shape. The display panel 110 may be formed to be flat, but is not limited thereto. For example, the display panel 110 may include curved surface portions formed at left and right ends thereof and having a constant curvature or a variable curvature. In addition, the display panel 110 may be flexibly formed to be curved, bent, folded, or rolled.

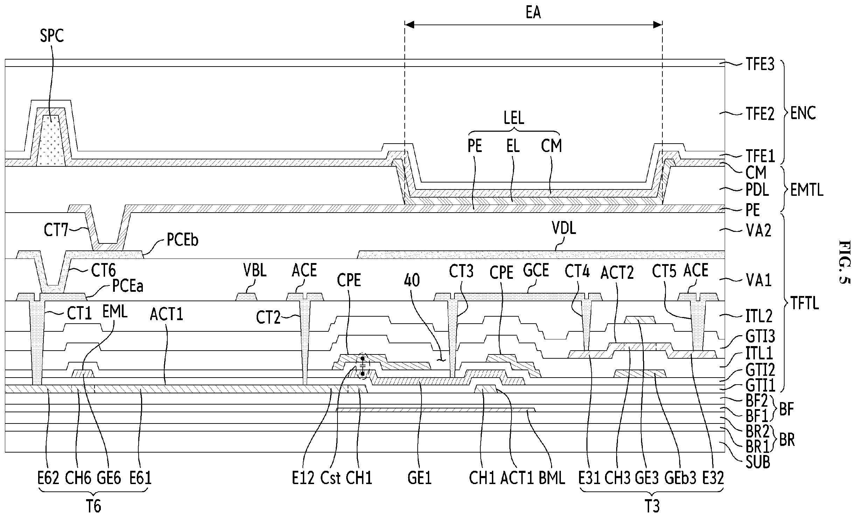

The display panel 110 may include a display area DA displaying an image and a non-display area NDA arranged around the display area DA. Alternatively, a substrate SUB (see FIG. 5) of the display panel 110 may include a display area DA and a non-display area NDA.

The display area DA may occupy most of the area of the display panel 110. The display area DA may be located at the center of the display panel 110. Pixels may be located in the display area DA in order to display images.

The non-display area NDA may be arranged to neighbor to the display area DA. The non-display area NDA may be an area outside (e.g., in a periphery, surrounding, or outside a footprint of) the display area DA. The non-display area NDA may be arranged to surround the display area DA. The non-display area NDA may be an edge area of the display panel 110.

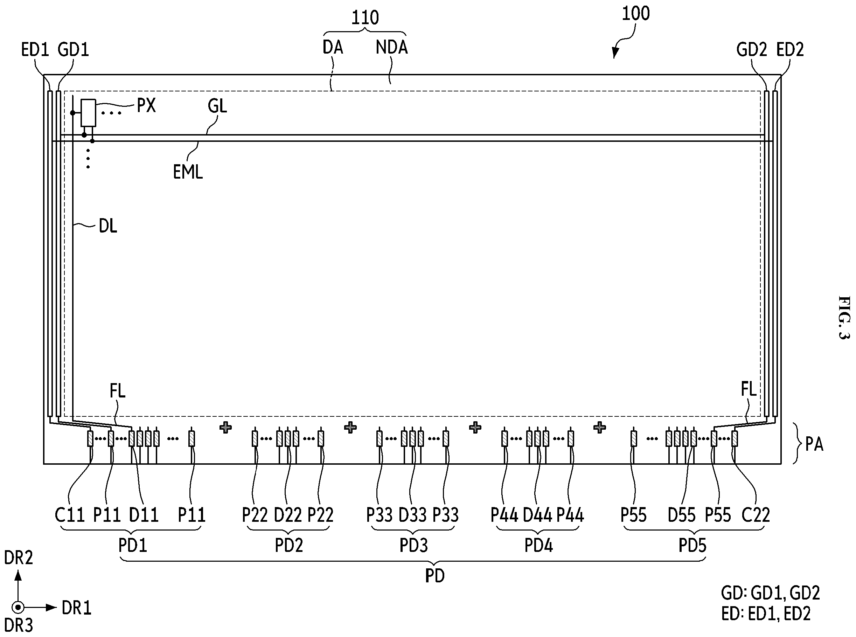

Pads PD (see FIG. 3) may be located in the non-display area NDA in order to be connected to the circuit boards 200. The pads may be located on an edge of one side of the display panel 110. For example, the pads may be located at an edge of a lower side of the display panel 110.

The circuit boards 200 may be located on a pad area PA located on the edge of one side of the display panel 110. The circuit boards 200 may be attached to the pads PD using a low-resistance and high-reliability material such as an anisotropic conductive film or a self assembly anisotropic conductive paste (SAP). For this reason, the circuit boards 200 may be electrically connected to signal lines of the display panel 110.

The display panel 110 may receive data voltages, source voltages, scan timing signals, and the like, through the circuit boards 200. Each of the circuit boards 200 may be a flexible printed circuit board, a printed circuit board, or a flexible film such as a chip on film.

The circuit board 200 may include a data driver DD. The data driver DD may generate the data voltages, the source voltages, the scan timing signals, and the like. The data driver DD may supply the data voltages, the source voltages, the scan timing signals, and the like, to the display panel 110 through the circuit boards 200.

The data driver DD may be formed as an integrated circuit (IC) and attached onto the circuit board 200. Alternatively, the data driver DD may be attached onto the display panel 110 in a chip on glass (COG) manner, a chip on plastic (COP) manner, or an ultrasonic bonding manner.

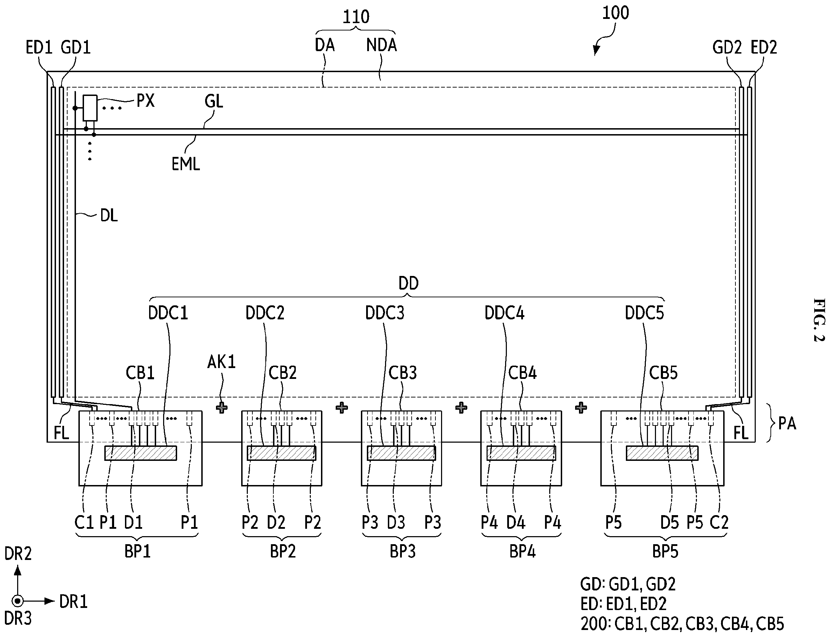

FIG. 2 is a plan view illustrating the display device according to some embodiments. FIG. 3 is a plan view illustrating a display panel of FIG. 2. FIG. 3 is a view illustrating components of FIG. 2 other than the data driver.

Referring to FIGS. 2 and 3, the display device 100 may include a plurality of pixels PX located in the display panel 110, and a gate driver, an emission driver, and a data driver that supply driving signals to the pixels PX. Here, the pixels PX may be located in the display area DA of the display panel 110, the gate driver and the emission driver may be located in the non-display area NDA of the display panel 110, and the data driver may be connected to the non-display area NDA of the display panel 110 through the circuit board 200.

The display device 100 may further include a power supply unit and a timing controller. The power supply unit may supply source voltages to the pixels PX, the gate driver, the emission driver, and the data driver. The timing controller may control operations of a first gate driver GD1, a second gate driver GD2, a first emission driver ED1, a second emission driver ED2, and the data driver.

The plurality of pixels PX may be located in the display area DA. The plurality of pixels PX may display images. The plurality of pixels PX may be connected to gate lines GL, emission control lines EML, data lines DL, and power lines. The gate line GL and the emission control line EML may each extend along the first direction DR1, and the data line DL may extend along the second direction DR2.

The non-display area NDA may include a pad area PA where a plurality of pads PD are located, as illustrated in FIG. 3. For example, the pad area PA may be located in a non-display area NDA (e.g., a lower non-display area) positioned on the lower side of the display area. The plurality of pads PD may be arranged along the first direction DR1.

A gate driver GD and an emission driver ED may be located in the non-display area NDA. For example, the gate driver GD may include the first gate driver GD1 and the second gate driver GD2. The emission driver ED may include the first emission driver ED1 and the second emission driver ED2. Here, the first gate driver GD1 and the first emission driver ED1 may be located in a non-display area NDA (e.g., a left non-display area) positioned on the left side of the display area DA, and the second gate driver GD2 and the second emission driver ED2 may be located in a non-display area NDA (e.g., a right non-display area) positioned on the right side of the display area DA.

The gate driver GD may drive the gate lines GL. For example, the first gate driver GD1 and the second gate driver GD2 may each supply gate signals to the gate lines GL. The gate lines GL may be connected to the first gate driver GD1 and the second gate driver GD2. For example, one side of each gate line GL may be electrically connected to the first gate driver GD1, and the other side of each gate line GL may be electrically connected to the second gate driver GD2.

The emission driver ED may drive the emission control lines EML. For example, the first emission driver ED1 and the second emission driver ED2 may each supply emission control signals to the emission control lines EML. The emission control lines EML may be connected to the first emission driver ED1 and the second emission driver ED2. For example, one side of each emission control line EML may be electrically connected to the first emission driver ED1, and the other side of each emission control line EML may be electrically connected to the second emission driver ED2.

The circuit board 200 may be electrically connected to the display panel 110 through the pads PD. The circuit board 200 may include a first circuit board CB1, a second circuit board CB2, a third circuit board CB3, a fourth circuit board CB4, and a fifth circuit board CB5. According to some embodiments, the first to fifth circuit boards CB1 to CB5 may be connected to at least one of the timing controller or the power supply unit through another circuit board, a connector, or the like.

Each of the circuit boards CB1 to CB5 may include a cluster terminal (or a cluster bump). For example, the first circuit board CB1 may include a first cluster terminal BP1, the second circuit board CB2 may include a second cluster terminal BP2, the third circuit board CB3 may include a third cluster terminal BP3, the fourth circuit board CB4 may include a fourth cluster terminal BP4, and the fifth circuit board CB5 may include a fifth cluster terminal BP5.

The first cluster terminal BP1 may include a plurality of first terminals (or bumps) C1, P1, and D1 located adjacent to each other on the first circuit board CB1, the second cluster terminal BP2 may include a plurality of second terminals P2 and D2 located adjacent to each other on the second circuit board CB2, the third cluster terminal BP3 include a plurality of third terminals P3 and D3 located adjacent to each other on the third circuit board CB3, the fourth cluster terminal BP4 includes a plurality of fourth terminals P4 and D4 located adjacent to each other on the fourth circuit board CB4, and the fifth cluster terminal BP5 may include a plurality of fifth terminals C2, P5, and D5 located adjacent to each other on the fifth circuit board CB5.

The data driver DD may include a plurality of driving circuits DDC1, DDC2, DDC3, DDC4, and DDC5 (hereinafter referred to as data driving circuits) arranged along the first direction DR1. For example, the data driver DD may include a first data driving circuit DDC1 mounted on the first circuit board CB1, a second data driving circuit DDC2 mounted on the second circuit board CB2, a third data driving circuit DDC3 mounted on the third circuit board CB3, a fourth data driving circuit DDC4 mounted on the fourth circuit board CB4, and a fifth data driving circuit DDC5 mounted on the fifth circuit board CB5.

Each of the data driving circuits DDC1 to DDC5 may be electrically connected to the pads PD of the display panel 110 through each of the circuit boards CB1 to CB5. For example, the first data driving circuit DDC1 may be electrically connected to first pads C11, P11, and D11 of the display panel 110 through the first terminals C1, P1, and D1 of the first circuit board CB1, the second data driving circuit DDC2 may be electrically connected to second pads P22 and D22 of the display panel 110 through the second terminals P2 and D2 of the second circuit board CB2, the third data driving circuit DDC3 may be electrically connected to third pads P33 and D33 of the display panel 110 through the third terminals P3 and D3 of the third circuit board CB3, the fourth data driving circuit DDC4 may be electrically connected to fourth pads P44 and D44 of the display panel 110 through the fourth terminals P4 and D4 of the fourth circuit board CB4, and the fifth data driving circuit DDC5 may be electrically connected to fifth pads C22, P55, and D55 of the display panel 110 through the fifth terminals C2, P5, and D5 of the fifth circuit board CB5.

A plurality of data lines DL may be connected to the data driver DD. For example, the plurality of data lines DL may be divided and connected to a plurality of data driving circuits DDC1 to DDC5. As a specific example, the plurality of data lines DL may include a plurality of first data lines connected to the first data driving circuit DDC1, a plurality of second data lines connected to the second data driving circuit DDC2, a plurality of third data lines connected to the third data driving circuit DDC3, a plurality of fourth data lines connected to the fourth data driving circuit DDC4, and a plurality of fifth data lines connected to the fifth data driving circuit DDC5.

The first terminals C1, P1, and D1 (e.g., the first cluster terminal BP1) may include a plurality of first control terminals C1, a plurality of first power terminals P1, and a plurality of first data terminals D1 arranged along the first direction DR1 on the first circuit board CB1. The first control terminals C1 may be connected to the timing controller located on another circuit board (hereinafter referred to as an external circuit board). The first power terminals P1 may be connected to the power supply unit located on the external circuit board. The first data terminals D1 may be connected to the first data driving circuit DDC1.

The second terminals P2 and D2 (e.g., the second cluster terminal BP2) may include a plurality of second power terminals P2 and a plurality of second data terminals D2 arranged along the first direction DR1 on the second circuit board CB2. The second power terminals P2 may be connected to the power supply unit located on the external circuit board. The second data terminals D2 may be connected to the second data driving circuit DDC2.

The third terminals P3 and D3 (e.g., the third cluster terminal BP3) may include a plurality of third power terminals P3 and a plurality of third data terminals D3 arranged along the first direction DR1 on the third circuit board CB3. The third power terminals P3 may be connected to the power supply unit located on the external circuit board. The third data terminals D3 may be connected to the third data driving circuit DDC3.

The fourth terminals P4 and D4 (e.g., the fourth cluster terminal BP4) may include a plurality of fourth power terminals P4 and a plurality of fourth data terminals D4 arranged along the first direction DR1 on the fourth circuit board CB4. The fourth power terminals P4 may be connected to the power supply unit located on the external circuit board. The fourth data terminals D4 may be connected to the fourth data driving circuit DDC4.

The fifth terminals C2, P5, and D5 (e.g., the fifth cluster terminal BP5) may include a plurality of second control terminals C2, a plurality of fifth power terminals P5, and a plurality of fifth data terminals D5 arranged along the first direction DR1 on the fifth circuit board CB5. The second control terminals P2 may be connected to the timing controller located on the external circuit board. The fifth power terminals P5 may be connected to the power supply unit located on the external circuit board. The fifth data terminals D5 may be connected to the fifth data driving circuit DDC5.

The first terminals C1, P1, and D1 of the first circuit board CB1, the second terminals P2 and D2 of the second circuit board CB2, the third terminals P3 and D3 of the third circuit board CB3, the fourth terminals P4 and D4 of the fourth circuit board CB4, and the fifth terminals C2, P5, and D5 of the fifth circuit board CB5 described above may be connected to the first pads C11, P11, and D11 of a first cluster pad PD1, the second pads P22 and D22 of a second cluster pad PD2, the third pads P33 and D33 of a third cluster pad PD3, the fourth pads P44 and D44 of a fourth cluster pad PD4, and the fifth pads C22, P55, and D55 of a fifth cluster pad PD5 of the display panel 110, respectively.

The first terminals C1, P1, and D1 may be arranged to correspond to (or overlap) the first pads C11, P11, and D11, respectively, the second terminals P2 and D2 may be arranged to correspond to (or overlap) the second pads P22 and D22, respectively, the third terminals P3 and D3 may be arranged to correspond to (or overlap) the third pads P33 and D33, respectively, the fourth terminals P4 and D4 may be arranged to correspond to (or overlap) the fourth pads P44 and D44, respectively, and the fifth terminals C2, P5, and D5 may be arranged to correspond to (or overlap) the fifth pads C22, P55, and D55, respectively.

The first pads C11, P11, and D11 may include a plurality of first control pads C11, a plurality of first power pads P11, and a plurality of first data pads D11 arranged along the first direction DR1 on the pad area PA of the display panel 110. The first control pads C11 may be connected to the first control terminals C1, respectively. In addition, the first control pads C11 may be connected to the first gate driver GD1 and the second gate driver GD2. The first power pads P11 may be connected to the first power terminals P1, respectively. In addition, the first power pads P11 may be connected to the first gate driver GD1, the first emission driver ED1, and the pixels PX. The first data pads D11 may be connected to the first data terminals D1, respectively. In addition, the first data pads D11 may be connected to the first data lines, respectively.

The second pads P22 and D22 may include a plurality of second power pads P22 and a plurality of second data pads D22 arranged along the first direction DR1 on the pad area PA of the display panel 110. The second power pads P22 may be connected to the second power terminals P2, respectively. In addition, the second power pads P22 may be connected to the pixels PX. The second data pads D22 may be connected to the second data terminals D2, respectively. In addition, the second data pads D22 may be connected to the second data lines, respectively.

The third pads P33 and D33 may include a plurality of third power pads P33 and a plurality of third data pads D33 arranged along the first direction DR1 on the pad area PA of the display panel 110. The third power pads P33 may be connected to the third power terminals P3, respectively. In addition, the third power pads P33 may be connected to the pixels PX. The third data pads D33 may be connected to the third data terminals D3, respectively. In addition, the third data pads D33 may be connected to the third data lines, respectively.

The fourth pads P44 and D44 may include a plurality of fourth power pads P44 and a plurality of fourth data pads D44 arranged along the first direction DR1 on the pad area PA of the display panel 110. The fourth power pads P44 may be connected to the fourth power terminals P4, respectively. In addition, the fourth power pads P44 may be connected to the pixels PX. The fourth data pads D44 may be connected to the fourth data terminals D4, respectively. In addition, the fourth data pads D44 may be connected to the fourth data lines, respectively.

The fifth pads C22, P55, and D55 may include a plurality of second control pads C22, a plurality of fifth power pads P55, and a plurality of fifth data pads D55 arranged along the first direction DR1 on the pad area PA of the display panel 110. The second control pads C22 may be connected to the second control terminals C2, respectively. The fifth power pads P55 may be connected to the fifth power terminals P5, respectively. In addition, the fifth power pads P55 may be connected to the pixels PX. The fifth data pads D55 may be connected to the fifth data terminals D5, respectively. In addition, the fifth data pads D55 may be connected to the fifth data lines, respectively.

The above-described first control pads C11 and the first gate driver GD1 may be electrically connected to each other through corresponding fan-out lines FL, and the other first control pads C11 and the first emission driver ED1 may be electrically connected to each other through corresponding fan-out lines FL.

The above-described second control pads C22 and the second gate driver GD2 may be electrically connected to each other through corresponding fan-out lines FL, and the other second control pads C22 and the second emission driver ED2 may be electrically connected to each other through corresponding fan-out lines FL.

The above-described first to fifth data pads D11, D22, D33, D44, and D55 may be electrically connected to the first to fifth data lines, respectively, through corresponding fan-out lines FL.

A gate timing control signal, an emission timing control signal, a gate clock signal, and an emission clock signal from the timing controller may be supplied to the first gate driver GD1 and the first emission driver ED1 through the first control terminals C1 of the first circuit board CB1 and the first control pads C11 of the display panel 110. For example, the gate timing control signal and the gate clock signal may be supplied to the first gate driver GD1, and the emission timing control signal and the emission clock signal may be supplied to the first emission driver ED1. Power signals from the power supply unit may be supplied to the first gate driver GD1, the first emission driver ED1, and the pixels PX through the first power terminals P1 of the first circuit board CB1 and the first power pads P11 of the display panel 110. The power signals may include, for example, a driving voltage, a common voltage, a first initialization voltage, a second initialization voltage, and a bias voltage. Data signals from the first data driving circuit DDC1 may be supplied to the first data lines, respectively, through the first data terminals D1 of the first circuit board CB1 and the first data pads D11 of the display panel 110.

Power signals from the power supply unit may be supplied to the pixels PX through the second power terminals P2 of the second circuit board CB2 and the second power pads P22 of the display panel 110. Data signals from the second data driving circuit DDC2 may be supplied to the second data lines, respectively, through the second data terminals D2 of the second circuit board CB2 and the second data pads D22 of the display panel 110.

Power signals from the power supply unit may be supplied to the pixels PX through the third power terminals P3 of the third circuit board CB3 and the third power pads P33 of the display panel 110. Data signals from the third data driving circuit DDC3 may be supplied to the third data lines, respectively, through the third data terminals D3 of the third circuit board CB3 and the third data pads D33 of the display panel 110.

Power signals from the power supply unit may be supplied to the pixels PX through the fourth power terminals P4 of the fourth circuit board CB4 and the fourth power pads P44 of the display panel 110. Data signals from the fourth data driving circuit DDC4 may be supplied to the fourth data lines, respectively, through the fourth data terminals D4 of the fourth circuit board CB4 and the fourth data pads D44 of the display panel 110.

A gate timing control signal, an emission timing control signal, a gate clock signal, and an emission clock signal from the timing controller may be supplied to the second gate driver GD2 and the second emission driver ED2 through the second control terminals C2 of the fifth circuit board CB5 and the second control pads C22 of the display panel 110. For example, the gate timing control signal and the gate clock signal may be supplied to the second gate driver GD2, and the emission timing control signal and the emission clock signal may be supplied to the second emission driver ED2. Power signals from the power supply unit may be supplied to the second gate driver GD2, the second emission driver ED2, and the pixels PX through the fifth power terminals P5 of the fifth circuit board CB5 and the fifth power pads P55 of the display panel 110. Data signals from the fifth data driving circuit DDC5 may be supplied to the fifth data lines, respectively, through the fifth data terminals D5 of the fifth circuit board CB5 and the fifth data pads D55 of the display panel 110.

At least one first alignment key AK1 may be located in the non-display area NDA. For example, the first alignment key AK1 may be located between adjacent circuit boards in the non-display area NDA. The first alignment key AK1 may be a mark for alignment between the circuit boards. The alignment between the circuit boards may be performed through the first alignment key AK1. In addition, it may be confirmed whether or not the circuit boards have been accurately aligned with each other, through the first alignment key AK1. The first alignment key AK1 may have, for example, a cross shape.

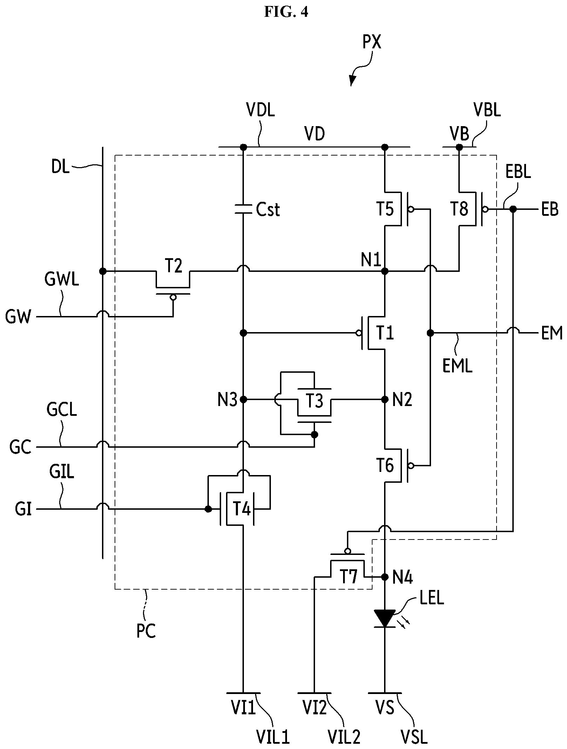

FIG. 4 is a circuit diagram of a pixel of the display device according to some embodiments. For example, FIG. 4 may be a circuit diagram of the pixel PX of FIG. 2. Although FIG. 4 illustrates various components in a pixel according to some embodiments, embodiments according to the present disclosure are not limited thereto, and according to some embodiments, the pixel may include additional components or fewer components without departing from the scope of embodiments according to the present disclosure.

The pixel PX may be connected to a first gate line GWL, a second gate line GCL, a third gate line GIL, a fourth gate line EBL, an emission control line EML, a data line DL, a driving voltage line VDL, a common voltage line VSL, a first initialization voltage line VIL1, a second initialization voltage line VIL2, and a bias voltage line VBL, as illustrated in FIG. 4.

The pixel PX may include a pixel circuit PC and a light emitting element LEL. The pixel circuit PC may include a first transistor T1, a second transistor T2, a third transistor T3, a fourth transistor T4, a fifth transistor T5, a sixth transistor T6, a seventh transistor T7, an eighth transistor T8, and a capacitor Cst.

The first transistor T1 may include a gate electrode, a source electrode, and a drain electrode. The first transistor T1 may control a source-drain current (hereinafter referred to as a driving current) according to a data voltage applied to the gate electrode. The driving current (e.g., Isd) flowing through a channel region of the first transistor T1 may be proportional to the square of a difference between a voltage Vsg between the source electrode and the gate electrode and a threshold voltage Vth of the first transistor T1 (Isd = k × (Vsg - Vth)²). Here, k refers to a proportional coefficient determined by a structure and physical properties of the first transistor T1, Vsg refers to a source-gate voltage of the first transistor T1, and Vth refers to the threshold voltage of the first transistor S1.

The light emitting element LEL may receive the driving current Isd to emit light. A light emission amount or luminance of the light emitting element LEL may be proportional to a magnitude of the driving current Isd.

The light emitting element LEL may be an organic light emitting diode including a first electrode, a second electrode, and an organic light emitting layer located between the first electrode and the second electrode. As another example, the light emitting element LEL may be an inorganic light emitting element including a first electrode, a second electrode, and an inorganic semiconductor located between the first electrode and the second electrode. As still another example, the light emitting element LEL may be a quantum dot light emitting element including a first electrode, a second electrode, and a quantum dot light emitting layer located between the first electrode and the second electrode. As still another example, the light emitting element LEL may be a micro light emitting diode.

The first electrode of the light emitting element LEL may be connected to a fourth node N4. The first electrode of the light emitting element LEL may be connected to a drain electrode of the sixth transistor T6 and a source electrode of the seventh transistor T7 through the fourth node N4. The second electrode of the light emitting element LEL may be connected to the common voltage line VSL. The second electrode of the light emitting element LEL may receive a second driving voltage VS (e.g., a low potential voltage) from the common voltage line VSL.

The second transistor T2 may be turned on by a first gate signal GW of the first gate line GWL to electrically connect the data line DL and a first node N1, which is the source electrode of the first transistor T1, to each other. The second transistor T2 may be turned on based on the first gate signal to supply a data voltage to the first node N1. A gate electrode of the second transistor T2 may be electrically connected to the first gate line GWL, a source electrode of the second transistor T2 may be electrically connected to the data line DL, and a drain electrode of the second transistor T2 may be electrically connected to the first node N1.

The third transistor T3 may be turned on by a second gate signal GC of the second gate line GCL to electrically connect a second node N2, which is the drain electrode of the first transistor T1, and a third node N3, which is the gate electrode of the first transistor T1, to each other. The third transistor T3 may be connected between the third node N3 and the second node N2. For example, a gate electrode of the third transistor T3 may be electrically connected to the second gate line GCL, a source electrode of the third transistor T3 may be electrically connected to the third node N3, and a drain electrode of the third transistor T3 may be electrically connected to the second node N2. The third transistor T3 may be a double gate transistor having two gate electrodes (e.g., a gate electrode and a counter gate electrode). The gate electrode and the counter gate electrode may be located at different layers so as to face each other.

The fourth transistor T4 may be turned on by a third gate signal GI of the third gate line GIL to electrically connect the third node N3, which is the gate electrode of the first transistor T1, and the first initialization voltage line VIL1 to each other. The fourth transistor T4 may be connected in series between the third node N3 and the first initialization voltage line VIL1. For example, a gate electrode of the fourth transistor T4 may be electrically connected to the third gate line GIL, a source electrode of the fourth transistor T4 may be electrically connected to the third node N3, and a drain electrode of the fourth transistor T4 may be electrically connected to the first initialization voltage line VIL1. The fourth transistor T4 may be a double gate transistor. The first initialization voltage line VIL1 may transmit a first initialization voltage VI1.

The fifth transistor T5 may be turned on by an emission control signal EM of the emission control line EML to electrically connect the driving voltage line VDL and the first node N1, which is the source electrode of the first transistor T1, to each other. A gate electrode of the fifth transistor T5 may be electrically connected to the emission control line EML, a source electrode of the fifth transistor T5 may be electrically connected to the driving voltage line VDL, and a drain electrode of the fifth transistor T5 may be electrically connected to the first node N1.

The sixth transistor T6 may be turned on by the emission control signal EM of the emission control line EML to electrically connect the second node N2, which is the drain electrode of the first transistor T1, and the fourth node N4, which is the first electrode of the light emitting element LEL, to each other. A gate electrode of the sixth transistor T6 may be electrically connected to the emission control line EML, a source electrode of the sixth transistor T6 may be electrically connected to the second node N2, and the drain electrode of the sixth transistor T6 may be electrically connected to the fourth node N4.

When the fifth transistor T5, the first transistor T1, and the sixth transistor T6 are all turned on, the driving current may be supplied to the light emitting element LEL.

The seventh transistor T7 may be turned on by a fourth gate signal EB of the fourth gate line EBL to electrically connect the fourth node N4, which is the first electrode of the light emitting element LEL, and the second initialization voltage line VIL2 to each other. The seventh transistor T7 may be turned on based on the fourth gate signal to discharge the first electrode of the light emitting element LEL to a second initialization voltage VI2. A gate electrode of the seventh transistor T7 may be electrically connected to the fourth gate line EBL, the source electrode of the seventh transistor T7 may be electrically connected to the fourth node N4, and a drain electrode of the seventh transistor T7 may be electrically connected to the second initialization voltage line VIL2. The second initialization voltage line VIL2 may transmit the second initialization voltage VI2.

The eighth transistor T8 may be turned on by the fourth gate signal EB of the fourth gate line EBL to electrically connect the bias voltage line VBL and the first node N1, which is the source electrode of the first transistor T1, to each other. The eighth transistor T8 may be turned on based on the fourth gate signal to supply a bias voltage VB to the first node N1. The eighth transistor T8 may relatively improve hysteresis of the first transistor T1 by supplying the bias voltage VB to the source electrode of the first transistor T1. A gate electrode of the eighth transistor T8 may be electrically connected to the fourth gate line EBL, a source electrode of the eighth transistor T8 may be electrically connected to the bias voltage line VBL, and a drain electrode of the eighth transistor T8 may be electrically connected to the first node N1.

Each of the first transistor T1, the second transistor T2, the fifth transistor T5, the sixth transistor T6, the seventh transistor T7, and the eighth transistor T8 may include a silicon-based active layer. For example, each of the first transistor T1, the second transistor T2, the fifth transistor T5, the sixth transistor T6, the seventh transistor T7, and the eighth transistor T8 may be a P-type transistor including an active layer made of low temperature polycrystalline silicon (LTPS). The active layer made of low temperature polycrystalline silicon may have high electron mobility and excellent turn-on characteristics. Accordingly, the display device 100 may stably and efficiently drive the plurality of pixels PX by including the transistors having the excellent turn-on characteristics. Each of the first transistor T1, the second transistor T2, the fifth transistor T5, the sixth transistor T6, the seventh transistor T7, and the eighth transistor T8 may output a current introduced into the source electrode to the drain electrode based on a gate low voltage applied to the gate electrode.

Each of the third transistor T3 and the fourth transistor T4 may be an N-type transistor including an oxide-based active layer. The transistor including the oxide-based active layer may have a coplanar structure in which a gate electrode thereof is located at a top. The transistor including the oxide-based active layer may output a current introduced into a drain electrode to a source electrode based on a gate high voltage applied to the gate electrode.

The capacitor Cst may be electrically connected between the third node N3, which is the gate electrode of the first transistor T1, and the driving voltage line VDL. For example, the capacitor Cst may have a first electrode electrically connected to the third node N3 and a second electrode electrically connected to the driving voltage line VDL to maintain a potential difference between the driving voltage line VDL and the gate electrode of the first transistor T1.

FIG. 5 is a cross-sectional view illustrating the display device according to some embodiments.

Referring to FIG. 5, the display device 100 may include a substrate SUB, a barrier layer BR, a thin film transistor layer TFTL, a light emitting element layer EMTL, and an encapsulation layer ENC. The barrier layer BR, the thin film transistor layer TFTL, the light emitting element layer EMTL, and the encapsulation layer ENC may be sequentially arranged along a third direction DR3 on the substrate SUB.

The substrate SUB may be a rigid substrate or be a flexible substrate that may be bent, folded, and rolled. The substrate SUB may be made of an insulating material such as glass, quartz, or a polymer resin. Examples of the polymer resin may include polyethersulphone (PES), polyacrylate (PA), polyarylate (PAR), polyetherimide (PEI), polyethylene naphthalate (PEN), polyethylene terepthalate (PET), polyphenylene sulfide (PPS), polyallylate, polyimide (PI), polycarbonate (PC), cellulose triacetate (CAT), cellulose acetate propionate (CAP), or combinations thereof. Alternatively, the substrate SUB may include a metal material.

As illustrated in FIG. 5, the barrier layer BR may be located on the substrate SUB. The barrier layer BR may be located on an entire surface of the substrate SUB. The barrier layer BR may be a film for protecting transistors T1 to T8 of the thin film transistor layer TFTL and light emitting layers EL of the light emitting element layer EMTL from moisture permeating through the substrate SUB vulnerable to moisture permeation.

The barrier layer BR may include a plurality of inorganic films that are alternately stacked. For example, the barrier layer BR may be formed as multiple films (e.g., a first barrier layer BR1 and a second barrier layer BR2) in which one or more inorganic films of a silicon nitride layer, a silicon oxynitride layer, a silicon oxide layer, a titanium oxide layer, and an aluminum oxide layer are alternately stacked.

A first pattern layer may be located on the barrier layer BR. For example, a light blocking layer BML may be located on the barrier layer BR. The light blocking layer BML may be located on the barrier layer BR so as to cover the overlap area (e.g., a first channel region CH1) between a first gate electrode GE1 and a first active layer ACT1. For example, the light blocking layer BML may be located on the barrier layer BR so as to overlap the first channel region CH1 of the first transistor T1, which is a driving transistor.

The light blocking layer BML may be made of a metal material such as chromium (Cr) or molybdenum (Mo), black ink, black dye, or the like. When the light blocking layer BML is made of the metal material, the light blocking layer BML may receive constant power. Accordingly, the light blocking layer BML may not be electrically floated, and electrical characteristics of a transistor (e.g., the first transistor T1) on the light blocking layer BML may be stabilized.

A buffer layer BF may be located on the light blocking layer BML. The buffer layer BF may be located on the entire surface of the substrate SUB including the barrier layer BR. The buffer layer BF may be a film for protecting the transistors T1 to T8 of the thin film transistor layer TFTL and the light emitting layers EL of the light emitting element layer EMTL from moisture permeating through the substrate SUB vulnerable to moisture permeation.

The buffer layer BF may include a plurality of inorganic films that are alternately stacked. For example, the buffer layer BF may be formed as multiple films (e.g., a first buffer layer BF1 and a second buffer layer BF2) in which one or more inorganic films of a silicon nitride layer, a silicon oxynitride layer, a silicon oxide layer, a titanium oxide layer, and an aluminum oxide layer are alternately stacked.

A second pattern layer may be located on the buffer layer BF. For example, the first active layer ACT1 may be located on the barrier layer BR. The first active layer ACT1 may include the first channel region CH1 of the first transistor T1, a second electrode E12 of the first transistor T1, the first channel region CH1 of the first transistor T1, a first electrode E61 of the sixth transistor T6, a second electrode E62 of the sixth transistor T6, and a sixth channel region CH6 of the sixth transistor T6.

The first active layer ACT1 may be an active layer made of low temperature polycrystalline silicon (LTPS).

A first gate insulating layer GTI1 may be located on the second pattern layer. For example, the first gate insulating layer GTI1 may be located on the first active layer ACT1. In this case, the first gate insulating layer GTI1 may be located on the entire surface of the substrate SUB including the first active layer ACT1.

The first gate insulating layer GTI1 may include at least one of tetraethylorthosilicate, (TEOS), silicon nitride (SiNₓ), or silicon oxide (SiO₂). As an example, the first gate insulating layer GTI1 may have a double-film structure in which a silicon nitride film having a thickness of 40 nm and a TEOS film having a thickness of 80 nm are sequentially stacked.

A third pattern layer may be located on the first gate insulating layer GTI1. For example, a second gate electrode GE2, the first gate electrode GE1, an eighth gate electrode GE8, an emission control line EML, a fifth gate electrode GE5, and a sixth gate electrode GE6 may be located on the first gate insulating layer GTI1.

In FIG. 5, an example in which the first gate electrode GE1, the sixth gate electrode GE6, and the emission control line EML are located on the first gate insulating layer GTI1 has been illustrated. The first gate electrode GE1 may be located on the first gate insulating layer GTI1 so as to overlap the first channel region CH1 of the first active layer ACT1. The sixth gate electrode GE6 of the emission control line EML may be located on the first gate insulating layer GTI1 so as to overlap the sixth channel region CH6 of the first active layer ACT1.

The third pattern layer may include at least one of molybdenum (Mo), copper (Cu), aluminum, or titanium (Ti), and may be formed as a single layer or multiple layers. For example, the first gate electrode GE1 may be formed as a triple film including a titanium film, an aluminum film, and a titanium film that are sequentially arranged along the third direction DR3 on the first gate insulating layer GTI1.

A second gate insulating layer GTI2 may be located on the third pattern layer. For example, the second gate insulating layer GTI2 may be located on the first gate electrode GE1, the sixth gate electrode GE6, and the emission control line EML. The second gate insulating layer GTI2 may be located on the entire surface of the substrate SUB including the first gate electrode GE1, the sixth gate electrode GE6, and the emission control line EML.

The second gate insulating layer GTI2 may include the same material as the first gate insulating layer GTI1 described above and have the same structure as the first gate insulating layer GTI1 described above.

A fourth pattern layer may be located on the second gate insulating layer GTI2. For example, a fourth counter gate electrode GEb4, a third counter gate electrode GEb3, and a capacitor electrode CPE may be located on the second gate insulating layer GTI2. In FIG. 5, an example in which the capacitor electrode CPE and the third counter gate electrode GEb3 are located on the second gate insulating layer GTI2 has been illustrated. The capacitor electrode CPE may be located on the second gate insulating layer GTI2 so as to overlap the first gate electrode GE1. The capacitor Cst may be formed between the capacitor electrode CPE and the first gate electrode GE1.

The fourth pattern layer may include the same material as the third pattern layer described above or have structure as the third pattern layer described above.

A first interlayer insulating layer ITL1 may be located on the fourth pattern layer. For example, the first interlayer insulating layer ITL1 may be located on the capacitor electrode CPE and the third counter gate electrode GEb3. In this case, the first interlayer insulating layer ITL1 may be located on the entire surface of the substrate SUB including the capacitor electrode CPE and the third counter gate electrode GEb3.

The first interlayer insulating layer ITL1 may include an inorganic film such as a silicon nitride layer, a silicon oxynitride layer, a silicon oxide layer, a titanium oxide layer, or an aluminum oxide layer. Meanwhile, the first interlayer insulating layer ITL1 may include a plurality of inorganic films.

A fifth pattern layer may be located on the first interlayer insulating layer ITL1. For example, a second active layer ACT2 may be located on the first interlayer insulating layer ITL1. The second active layer ACT2 may be arranged on the first interlayer insulating layer ITL1 so as to overlap the third counter gate electrode GEb3. The second active layer ACT2 may include a first electrode E31 of the third transistor T3, a second electrode E32 of the third transistor T3, and a third channel region CH3 of the third transistor T3. The third channel region CH3 of the second active layer ACT2 may overlap the third counter gate electrode GEb3.

The second active layer ACT2 may be an oxide-based active layer. For example, the second active layer ACT2 may be an oxide semiconductor including indium-gallium-zinc-oxide (IGZO) or indium-gallium-zinc-tin oxide (IGZTO).

A third gate insulating layer GTI3 may be located on the fifth pattern layer. For example, the third gate insulating layer GTI3 may be located on the second active layer ACT2. The third gate insulating layer GTI3 may be arranged on the entire surface of the substrate SUB including the second active layer ACT2.

The third gate insulating layer GTI3 may include the same material as the first gate insulating layer GTI1 described above and have the same structure as the first gate insulating layer GTI1 described above.

A sixth pattern layer may be located on the third gate insulating layer GTI3. For example, a fourth gate electrode GE4 and a third gate electrode GE3 may be located on the third gate insulating layer GTI3.

In FIG. 5, an example in which the third gate electrode GE3 is located on the third gate insulating layer GTI3 has been illustrated. The third gate electrode GE3 may be arranged to overlap the third channel region CH3 of the second active layer ACT2.

The sixth pattern layer may include the same material as the third pattern layer described above or have structure as the third pattern layer described above.

A second interlayer insulating layer ITL2 may be located on the sixth pattern layer. For example, the second interlayer insulating layer ITL2 may be located on the third gate electrode GE3. The second interlayer insulating layer ITL2 may be arranged on the entire surface of the substrate SUB including the third gate electrode GE3.

The second interlayer insulating layer ITL2 may include the same material as the first interlayer insulating layer ITL1 described above and have the same structure as the first interlayer insulating layer ITL1 described above.

A seventh pattern layer may be located on the second interlayer insulating layer ITL2. For example, the first initialization voltage line VIL1, the third gate line GIL, a data connection electrode DCE, the first gate line GWL, the second gate line GCL, a gate connection electrode GCE, an active connection electrode ACE, the bias voltage line VBL, a capacitor connection electrode CCE, a lower pixel connection electrode PCEa, the fourth gate line EBL, and the second initialization voltage line VIL2 may be located on the second interlayer insulating layer ITL2.

In FIG. 5, an example in which the gate connection electrode GCE, the active connection electrode ACE, the bias voltage line VBL, and the lower pixel PX connection electrode PCEa are located on the second interlayer insulating layer ITL2 has been illustrated. The lower pixel PX connection electrode PCEa may be connected to the second electrode E62 of the sixth transistor T6 through a first contact hole CT1 penetrating through the second interlayer insulating layer ITL2, the third gate insulating layer GTI3, the first interlayer insulating layer ITL1, the second gate insulating layer GTI2, and the first gate the insulating layer GTI1. The active connection electrode ACE may be connected to the second electrode E12 of the first transistor T1 and the first electrode E61 of the sixth transistor T6 through a second contact hole CT2 penetrating through the second interlayer insulating layer ITL2, the third gate insulating layer GTI3, the first interlayer insulating layer ITL1, the second gate insulating layer GTI2, and the first gate the insulating layer GTI1. In addition, the active connection electrode ACE may be connected to the second electrode E32 of the third transistor T3 through a fifth contact hole CT5 penetrating through the second interlayer insulating layer ITL2 and the third gate insulating layer GTI3. The gate connection electrode GCE may be connected to the first gate electrode GE1 through a third contact hole CT3 penetrating through the second interlayer insulating layer ITL2, the third gate insulating layer GTI3, the first interlayer insulating layer ITL1, a hole 40 of the capacitor electrode CPE, and the second gate insulating layer GTI2. In addition, the gate connection electrode GCE may be connected to the first electrode E31 of the third transistor T3 through a fourth contact hole CT4 penetrating through the second interlayer insulating layer ITL2 and the third gate insulating layer GTI3.

The seventh pattern layer may include the same material as the third pattern layer described above or have structure as the third pattern layer described above.

A first planarization layer VA1 may be located on the seventh pattern layer. For example, the first planarization layer VA1 may be located on the gate connection electrode GCE, the active connection electrode ACE, the bias voltage line VBL, and the lower pixel PX connection electrode PCEa. The first planarization layer VA1 may be located on the entire surface of the substrate SUB including the gate connection electrode GCE, the active connection electrode ACE, the bias voltage line VBL, and the lower pixel PX connection electrode PCEa.

The first planarization layer VA1 may include an organic film made of an acrylic resin, an epoxy resin, a phenolic resin, a polyamide resin, a polyimide resin, or the like.

An eighth pattern layer may be located on the first planarization layer VA1. For example, a first data line DL1, the driving voltage line VDL, and an upper pixel PX connection electrode PCEb may be located on the first planarization layer VA1. In FIG. 5, an example in which the driving voltage line VDL and the upper pixel PX connection electrode PCEb are located on the first planarization layer VA1 has been illustrated.

The upper pixel PX connection electrode PCEb may be connected to the lower pixel PX connection electrode PCEa through a sixth contact hole CT6 penetrating through the first planarization layer VA1.

The eighth pattern layer may include the same material as the third pattern layer described above or have structure as the third pattern layer described above.

A second planarization layer VA2 may be located on the eighth pattern layer. For example, the second planarization layer VA2 may be located on the driving voltage line VDL and the upper pixel PX connection electrode PCEb. The second planarization layer VA2 may be arranged on the entire surface of the substrate SUB including the driving voltage line VDL and the upper pixel PX connection electrode PCEb.

The second planarization layer VA2 may include the same material as the first planarization layer VA1 described above and have the same structure as the planarization layer VA1 described above.

A ninth pattern layer may be located on the second planarization layer VA2. For example, the light emitting element layer EMTL including the ninth pattern layer may be located on the second planarization layer VA2. For example, a pixel PX electrode PE may be arranged as a ninth pattern layer on the second planarization layer VA2. The pixel PX electrode PE may be connected to the upper pixel PX connection electrode PCEb through a seventh contact hole CT7 penetrating through the second planarization layer VA2.

The light emitting element layer EMTL described above may further include a light emitting element LEL and a bank PDL (or a pixel defining film) in addition to the ninth pattern layer described above.

The light emitting element LEL may include a pixel electrode PE, a light emitting layer EL, and a common electrode CM. An emission area EA refers to an area where the pixel electrode PE, the light emitting layer EL, and the common electrode CM are sequentially stacked and holes from the pixel electrode PE and electrons from the common electrode CM are combined with each other in the light emitting layer to emit light. In this case, the pixel electrode PE may be an anode electrode of the light emitting element LEL, and the common electrode CM may be a cathode electrode of the light emitting element LEL.

In a top emission structure in which light is emitted toward the common electrode CM based on the light emitting layer EL, the pixel electrode PE may be formed as a single layer made of molybdenum (Mo), titanium (Ti), copper (Cu), or aluminum (Al) or formed as a stacked structure (Ti/Al/Ti) of aluminum and titanium, a stacked structure (ITO/AI/ITO) of aluminum and indium tin oxide (ITO), an APC alloy, and a stacked structure (ITO/APC/ITO) of an APC alloy and ITO in order to increase reflectivity. The APC alloy is an alloy of silver (Ag), palladium (Pd), and copper (Cu).

The bank PDL may serve to define the emission areas EA of the pixels PX. To this end, the bank PDL may be arranged to expose a partial area of the pixel electrode PE on the second planarization layer VA2. The bank PDL may cover an edge of the pixel electrode PE. Meanwhile, the bank PDL may be located in the seventh contact hole CT7 penetrating through the second planarization layer VA2. For this reason, the seventh contact hole CT7 penetrating through the second planarization layer VA2 may be filled with the bank PDL. The bank PDL may be formed as an organic film made of an acrylic resin, an epoxy resin, a phenolic resin, a polyamide resin, a polyimide resin, or the like.

A spacer SPC may be located on the bank PDL. The spacer SPC may serve to support a mask during a process of manufacturing the light emitting layer EL. The spacer SPC may be formed as an organic film made of an acrylic resin, an epoxy resin, a phenolic resin, a polyamide resin, a polyimide resin, or the like.

The light emitting layer EL may be formed on the pixel electrode PE. The light emitting layer EL may include an organic material to emit light of a color (e.g., a set or predetermined color). For example, the light emitting layer EL may include a hole transporting layer, an organic material layer, and an electron transporting layer. The organic material layer may include a host and a dopant. The organic material layer may include a material emitting light (e.g., set or predetermined light), and may be formed using a phosphorescent material or a fluorescent material.

The light emitting element LEL described above may be provided for each pixel PX. For example, a first pixel may include a first light emitting element, a second pixel may include a second light emitting element, and a third pixel may include a third light emitting element. The first light emitting element, the second light emitting element, and the third light emitting element may provide light of different colors. For example, the first light emitting element may emit light of a first color, the second light emitting element may emit light of a second color, and the third light emitting element may emit light of a third color.

For example, a light emitting layer of the first light emitting element emitting the light of the first color may be made of a phosphorescent material including a host material including 4,4'-bis(N-carbazolyl)-1,1'-biphenyl (CBP) or 1,3-bis(carbazol-9-yl) (mCP) and including a dopant including one or more selected among bis(1-phenylisoquinoline)acetylacetonate iridium (PlQlr(acac)), bis(1-phenylquinoline)acetylacetonate iridium (PQIr(acac)), tris(1-phenylquinoline)iridium (PQIr), and platinum octaethylporphyrin (PtOEP). Alternatively, the light emitting layer of the first light emitting element emitting the light of the first color may be made of a fluorescent material including PBD: Eu(DBM)₃(Phen) or perylene, but is not limited thereto.

A light emitting layer of the second light emitting element emitting the light of the second color may be made of a phosphorescent material including a host material including CBP or mCP and including a dopant material including fac-tris(2-phenylpyridine)iridium (Ir(ppy)3). Alternatively, the light emitting layer of the second light emitting element emitting the light of the second color may be made of a fluorescent material including tris(8-hydroxyquinolino)aluminum (Alq3), but is not limited thereto.

A light emitting layer of the third light emitting element emitting the light of the third color may be made of a phosphorescent material including a host material including CBP or mCP and including a dopant material including (4,6-F2ppy)2Irpic or L2BD111, but is not limited thereto.

The common electrode CM may be located on each light emitting layer (e.g., EL). The common electrode CM may be arranged to cover each light emitting layer EL. The common electrode CM may be a common layer arranged in common in each pixel PX. A capping layer may be formed on the common electrode CM.

In the top emission structure, the common electrode CM may be made of a transparent conductive material (TCO) such as ITO or indium zinc oxide (IZO) capable of transmitting light therethrough or a semi-transmissive conductive material such as magnesium (Mg), silver (Ag), or an alloy of magnesium (Mg) and silver (Ag). When the common electrode CM is made of the semi-transmissive conductive material, emission efficiency may be increased by a micro cavity.

The encapsulation layer ENC may be located on the light emitting element layer EMTL. The encapsulation layer ENC may include at least one inorganic film TFE1 and TFE3 in order to prevent or reduce instances of contaminants such as oxygen or moisture permeating into the light emitting element layer EMTL. In addition, the encapsulation layer ENC may include at least one organic film TFE2 in order to protect the light emitting element layer EMTL from foreign substances such as dust. For example, the encapsulation layer ENC may include a first encapsulation inorganic film TFE1, an encapsulation organic film TFE2, and a second encapsulation inorganic film TFE3.

The first encapsulation inorganic film TFE1 may be located on the common electrode CM, the encapsulation organic film TFE2 may be located on the first encapsulation inorganic film TFE1, and the second encapsulation inorganic film TFE3 may be located on the encapsulation organic film TFE2. The first encapsulation inorganic film TFE1 and the second encapsulation inorganic film TFE3 may be formed as multiple films in which one or more inorganic films of a silicon nitride layer, a silicon oxynitride layer, a silicon oxide layer, a titanium oxide layer, and an aluminum oxide layer are alternately stacked. The encapsulation organic film TFE2 may be an organic film made of an acrylic resin, an epoxy resin, a phenolic resin, a polyamide resin, a polyimide resin, or the like.

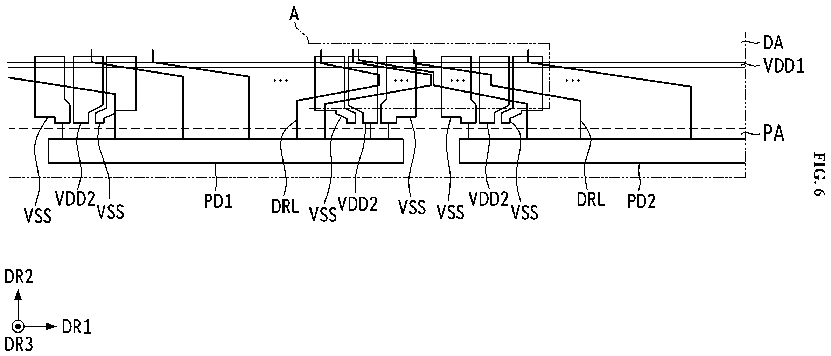

FIG. 6 is a plan view illustrating a non-display area of the display device according to some embodiments. FIG. 6 illustrates a portion between the pad area PA where the first and second cluster pads PD1 and PD2 of FIG. 3 are located and the display area DA.

Referring to FIG. 6, a first voltage line VDD1, second voltage lines VDD2, common lines VSS, data routing lines DRL, and the first and second cluster pads PD1 and PD2 may be located in the non-display area NDA.

A driving voltage applied from the circuit board 200 (see FIG. 1) may be transferred to the first voltage line VDD1 through the second driving voltage lines VDD2. The driving voltage of the first voltage line VDD1 may be transferred to the driving voltage line VDL (see FIG. 4) of the display area DA. The first driving voltage line VDD1 may extend in the first direction DR1 on the lower side of the display area DA.

The second voltage lines VDD2 may be located between the pad area PA and the first voltage line VDD1. The second voltage lines VDD2 may extend in the second direction DR2 to connect the pad area PA and the first voltage line VDD1 to each other. A plurality of second voltage lines VDD2 may be provided. For example, the second voltage lines VDD2 may be located on both sides of the first cluster pad PD1, but are not limited thereto. The second voltage lines VDD2 may transfer the driving voltage applied from the circuit board 200 (see FIG. 1) to the first voltage line VDD1.

The common lines VSS may be located between the pad area PA and the first voltage line VDD1. The common lines VSS may each extend in the second direction DR2 to connect the pad area PA and the display area DA to each other. A plurality of common lines VSS may be provided. For example, two common lines VSS may be located on each of both sides of the first cluster pad PD1, but are not limited thereto. For example, the common lines VSS may be arranged to neighbor to each other with the second voltage line VDD2 interposed therebetween. The common lines VSS may transfer a low potential voltage applied from the circuit board to the common voltage line VSL (see FIG. 4) of the display area DA.

The data routing lines DRL may extend from the display area DA to the pad area PA. The data routing lines DRL may be connected to the data lines DL (see FIG. 4) of the display area DA and extend to the pad area PA. The data routing lines DRL may transfer data voltages applied from the circuit board to the data lines DL (see FIG. 4) of the display area DA.

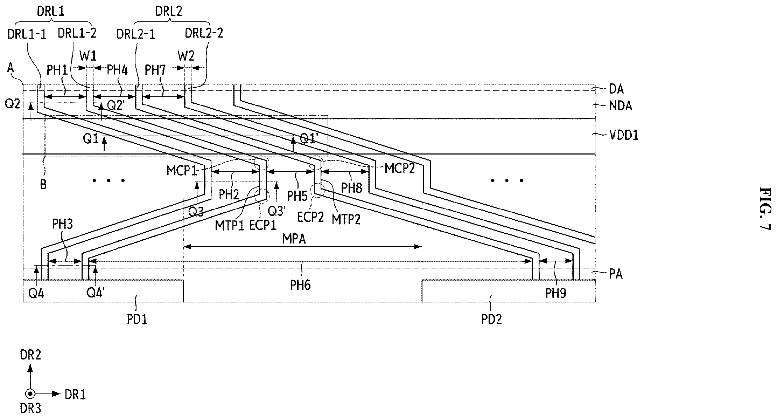

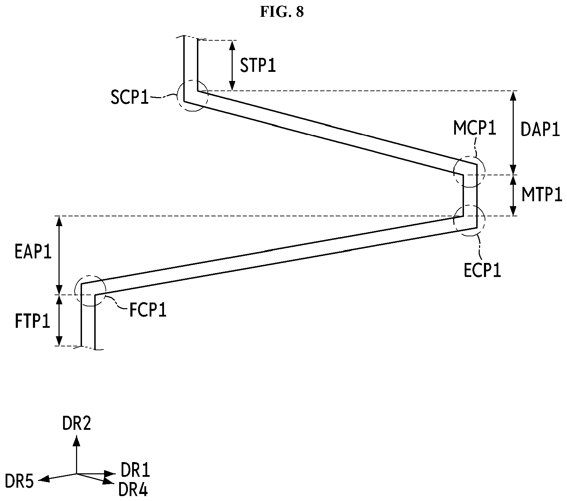

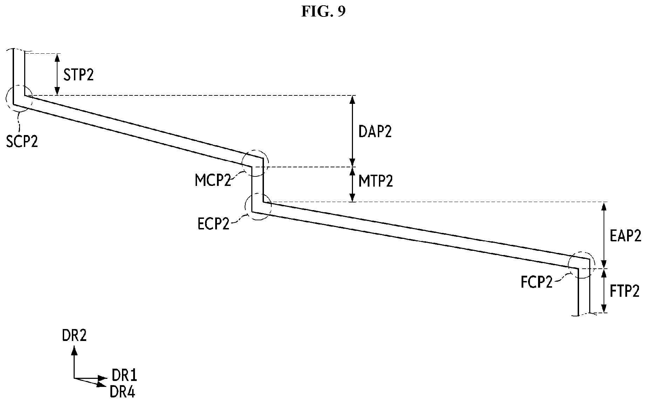

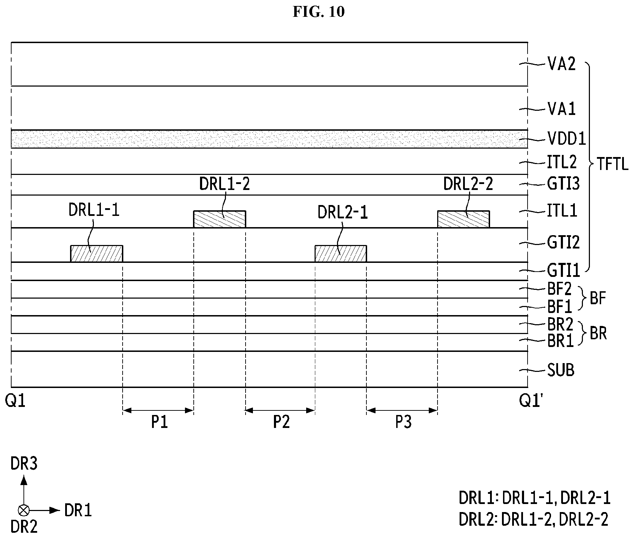

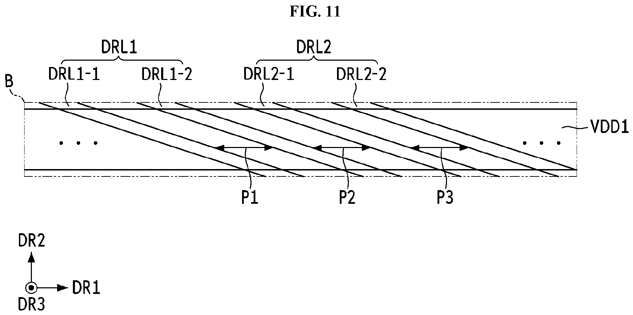

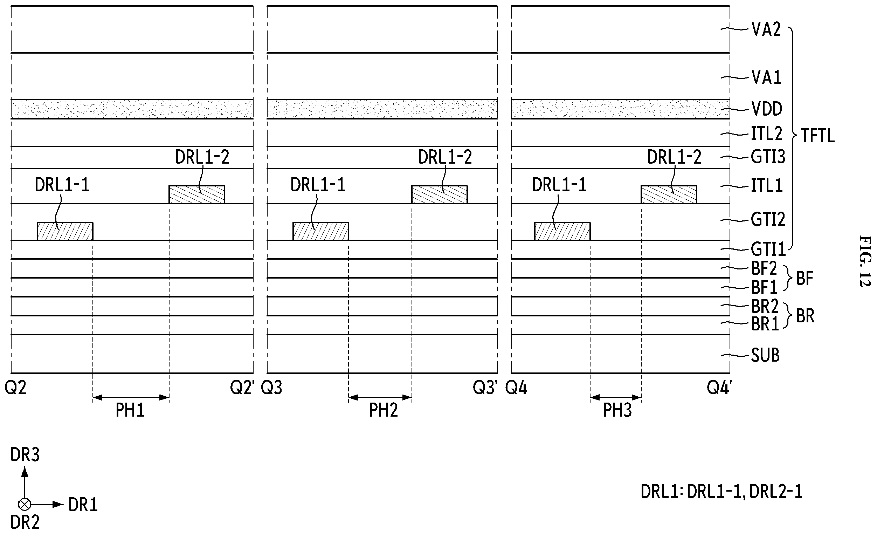

FIG. 7 is an enlarged plan view illustrating area A of FIG. 6. FIG. 8 is a schematic plan view illustrating a first routing line. FIG. 9 is a schematic plan view illustrating a second routing line. FIG. 10 is a cross-sectional view taken along the line Q1-Q1' in FIG. 7. FIG. 11 is an enlarged plan view illustrating area B of FIG. 7. FIG. 12 is a cross-sectional view taken along the lines Q2-Q2', Q3-Q3', and Q4-Q4' of FIG. 7.

FIG. 6 illustrates the data routing lines DRL and the first voltage line VDD1 in the non-display area NDA.

Referring to FIGS. 7 to 12 in conjunction with FIG. 6, the data routing lines DRL may include first routing lines DRL1 and second routing lines DRL2. The respective routing lines DRL1 and DRL2 may be connected to the data lines DL (see FIG. 4) of the corresponding pixels PX, respectively, to supply data signals.

The first routing lines DRL1 may extend from the display area DA and be connected to the first cluster pad PD1. The first routing lines DRL1 may receive data signals supplied from the first circuit board CB1 (see FIG. 2) through the first cluster pad PD1.

The second routing lines DRL2 may extend from the display area DA and be connected to the second cluster pad PD2. The second routing lines DRL2 may receive data signals supplied from the second circuit board CB2 (see FIG. 2) through the second cluster pad PD2.

According to some embodiments, the first routing line DRL1 and the second routing line DRL2 may have the same width. For example, a width W1 of the first routing line DRL1 and a width W2 of the second routing line DRL2 may be the same as each other. When the width W1 of the first routing line DRL1 and the width W2 of the second routing line DRL2 are the same as each other, it may be possible to prevent or reduce the occurrence of a difference between the data signals by making line resistances of the first routing line DRL1 and the second routing line DRL2 the same as each other.

The first routing line DRL1 and the second routing line DRL2 may have the same length. For example, a length of the first routing line DRL1 and a length of the second routing line DRL2 may be the same as each other. Here, the length may refer to a length extending from a boundary between the display area DA and the non-display area NDA to the pad area PA. When the length of the first routing line DRL1 and the length of the second routing line DRL2 are the same as each other, it may be possible to prevent or reduce instances of the occurrence of the difference between the data signals by making the line resistances of the first routing line DRL1 and the second routing line DRL2 the same as each other.

According to some embodiments, the first routing lines DRL1 and the second routing lines DRL2 may have different shapes in order to have the same line resistance. For example, the first routing lines DRL1 and the second routing lines DRL2 may have detour shapes.

Referring to FIG. 8, the first routing line DRL1 may include a first front end portion STP1, a first middle portion MTP1, a first rear end portion FTP1, a first connection portion DAP1, and a first extension portion EAP1.

The first front end portion STP1 may be a portion extending from the display area DA to the non-display area NDA. The first front end portion STP1 may extend in the second direction DR2 (e.g., a vertical direction). The first front end portion STP1 may be arranged so as not to overlap the first power line VDD1 in a thickness direction in a plan view.

The first connection portion DAP1 may be a portion bent and extending from the first front end portion STP1. The first connection portion DAP1 may extend in a fourth direction DR4 (e.g., a direction forming an acute angle with the first direction DR1). For example, the first connection portion DAP1 may be bent and extend from the first front end portion STP1 in the fourth direction DR4. The first connection portion DAP1 may extend in a direction toward an adjacent second routing line DRL2. The first connection portion DAP1 may be arranged to overlap the first power line VDD1 in the thickness direction in a plan view.

The first middle portion MTP1 may be a portion bent and extending from the first connection portion DAP1. The first middle portion MTP1 may extend in the second direction DR2 (e.g., the vertical direction). For example, the first middle portion MTP1 may be bent and extend from the first connection portion DAP1 in the second direction DR2. The first middle portion MTP1 may be arranged so as not to overlap the first power line VDD1 in the thickness direction in a plan view.

The first extension portion EAP1 may be a portion bent and extending from the first middle portion MTP1. The first extension portion EAP1 may extend in a fifth direction DR5 (e.g., a direction forming an obtuse angle with the second direction DR2). For example, the first extension portion EAP1 may be bent and extend from the first middle portion MTP1 in a direction toward an adjacent first circuit board CB1. The first extension portion EAP1 may be arranged so as not to overlap the first power line VDD1 in the thickness direction in a plan view.

The first rear end portion FTP1 may be a portion bent and extending from the first extension portion EAP1. The first rear end portion FTP1 may extend in the second direction DR2 (e.g., the vertical direction). For example, the first rear end portion FTP1 may be bent and extend from the first extension portion EAP1 in the vertical direction.

The first routing line DRL1 may include four bent portions SCP1, MCP1, ECP1, and FCP1. For example, the first routing line DRL1 may include a first front end bent portion SCP1, a first middle bent portion MCP1, a first extension bent portion ECP1, and a first rear end bent portion FCP1.

The first front end bent portion SCP1 may be located between the first front end portion STP1 and the first connection portion DAP1. The first front end bent portion SCP1 may be arranged so as not to overlap the first power line VDD1 in the thickness direction in a plan view.

The first middle bent portion MCP1 may be located between the first connection portion DAP1 and the first middle portion MTP1. The first middle bent portion MCP1 may be arranged so as not to overlap the first power line VDD1 in the thickness direction in a plan view. The first power line VDD1 may be located between the first front end bent portion SCP1 and the first middle bent portion MCP1 in a plan view.

The first extension bent portion ECP1 may be located between the first middle portion MTP1 and the first extension portion EAP1. The first extension bent portion ECP1 may be arranged to be farther away from the first power line VDD1 than the first middle bent portion MCP1 is.

The first rear end bent portion FCP1 may be located between the first extension portion EAP1 and the first rear end portion FTP1. The first rear end bent portion FCP1 may be located adjacent to the pad area PA.

As illustrated in FIG. 8, the first routing line DRL1 may be formed in a detour shape toward an adjacent second cluster pad PD2 rather than being directly directed toward the first cluster pad PD1. In this way, when the first routing line DRL1 is formed in the detour shape, lengths of the first routing line DRL1 and the second routing line DRL2 adjacent to each other may be compensated for to become the same as each other. Accordingly, it may be possible to prevent or reduce RC delay by making line resistances of the routing lines DRL1 and DRL2 the same as each other.

Referring to FIG. 9, the second routing line DRL2 may include a second front end portion STP2, a second middle portion MTP2, a second rear end portion FTP2, a second connection portion DAP2, and a second extension portion EAP2.

The second front end portion STP2 may be a portion extending from the display area DA to the non-display area NDA. The second front end portion STP2 may extend in the second direction DR2 (e.g., the vertical direction). The second front end portion STP2 may be arranged so as not to overlap the first power line VDD1 in the thickness direction in a plan view.

The second connection portion DAP2 may be a portion bent and extending from the second front end portion STP2. The second connection portion DAP2 may extend in the fourth direction DR4 (e.g., the direction forming the acute angle with the first direction DR1). For example, the second connection portion DAP2 may be bent and extend from the second front end portion STP2 in the fourth direction DR4. The second connection portion DAP2 may extend in a direction toward the adjacent second cluster pad PD2. The second connection portion DAP2 may be arranged to overlap the first power line VDD1 in the thickness direction in a plan view.

The second middle portion MTP2 may be a portion bent and extending from the second connection portion DAP2. The second middle portion MTP2 may extend in the second direction DR2 (e.g., the vertical direction). For example, the second middle portion MTP2 may be bent and extend from the second connection portion DAP2 in the second direction DR2. The second middle portion MTP2 may be arranged so as not to overlap the first power line VDD1 in the thickness direction in a plan view.

The second extension portion EAP2 may be a portion bent and extending from the second middle portion MTP2. The second extension portion EAP2 may extend in the fourth direction DR4. For example, the second extension portion EAP2 may be bent and extend from the second middle portion MTP2 in the direction toward the adjacent second cluster pad PD2. The second extension portion EAP2 may be arranged so as not to overlap the first power line VDD1 in the thickness direction in a plan view.

The second rear end portion FTP2 may be a portion bent and extending from the second extension portion EAP2. The second rear end portion FTP21 may extend in the second direction DR2 (e.g., the vertical direction). For example, the second rear end portion FTP2 may be bent and extend from the second extension portion EAP2 in the vertical direction.

The second routing line DRL2 may include four bent portions SCP2, MCP2, ECP2, and FCP2. For example, the second routing line DRL2 may include a second front end bent portion SCP2, a second middle bent portion MCP2, a second extension bent portion ECP2, and a second rear end bent portion FCP2.

The second front end bent portion SCP2 may be located between the second front end portion STP2 and the second connection portion DAP2. The second front end bent portion SCP2 may be arranged so as not to overlap the first power line VDD1 in the thickness direction in a plan view.

The second middle bent portion MCP2 may be located between the second connection portion DAP2 and the second middle portion MTP2. The second middle bent portion MCP2 may be arranged so as not to overlap the first power line VDD1 in the thickness direction in a plan view. The first power line VDD1 may be located between the second front end bent portion SCP2 and the second middle bent portion MCP2 in a plan view.

The second extension bent portion ECP2 may be located between the second middle portion MTP2 and the second extension portion EAP2. The second extension bent portion ECP2 may be arranged to be farther away from the first power line VDD1 than the second middle bent portion MCP2 is.

The second rear end bent portion FCP2 may be located between the second extension portion EAP2 and the second rear end portion FTP2. The second rear end bent portion FCP2 may be located adjacent to the pad area PA.

The second routing line DRL2 may be formed in a detour shape by including the bent portions rather than being directly directed toward the second cluster pad PD2. In this way, when the second routing line DRL2 is formed in the detour shape, lengths of the first routing line DRL1 and the second routing line DRL2 adjacent to each other may be compensated for to become the same as each other. Accordingly, it may be possible to prevent or reduce RC delay by making line resistances of the routing lines DRL1 and DRL2 the same as each other.

As illustrated in FIGS. 6 to 9, the first front end portion STP1 of the first routing line DRL1 may be arranged in parallel with the second front end portion STP2 of the second routing line DRL2. The first connection portion DAP1 of the first routing line DRL1 may be arranged in parallel with the second connection portion DAP2 of the second routing line DRL2. The first middle portion MTP1 of the first routing line DRL1 may be arranged in parallel with the second middle portion MTP2 of the second routing line DRL2. The first rear end portion FTP1 of the first routing line DRL1 may be arranged in parallel with the second rear end portion FTP2 of the second routing line DRL2.

The first extension portion EAP1 of the first routing line DRL1 may extend in a different direction from the second extension portion EAP2 of the second routing line DRL2. For example, the first extension portion EAP1 of the first routing line DRL1 may extend in the fifth direction DR5, and the second extension portion EAP2 of the second routing line DRL2 may extend in the fourth direction DR4.

As illustrated in FIG. 7, the first middle portion MTP1 of the first routing line DRL1 and the second middle portion MTP2 of the second routing line DRL2 arranged adjacent to each other among the first routing lines DRL1 and the second routing line DRL2 may be located in an area between the first cluster pad PD1 and the second cluster pad PD2 (e.g., an area indicated by 'MPA'). Here, the area MPA between the first cluster pad PD1 and the second cluster pad PD2 refers to an area between a pad adjacent to the second cluster pad PD2 among pads located in the first cluster pad PD1 and a pad adjacent to the first cluster pad PD1 among pads located in the second cluster pad PD2. For example, the first middle portion MTP1 of the first routing line DRL1 and the second middle portion MTP2 of the second routing line DRL2 may be located in the area MPA between the first cluster pad PD1 and the second cluster pad PD2. For example, the first middle portion MTP1 of the first routing line DRL1 and the second middle portion MTP2 of the second routing line DRL2 may overlap the area MPA between the first cluster pad PD1 and the second cluster pad PD2 in the second direction DR2 in a plan view.

In addition, the first middle bent portion MCP1 of the first routing line DRL1 and the second middle bent portion MCP2 of the second routing line DRL2 may be located in the area MPA between the first cluster pad PD1 and the second cluster pad PD2. For example, the first middle bent portion MCP1 of the first routing line DRL1 and the second middle bent portion MCP2 of the second routing line DRL2 may overlap the area MPA between the first cluster pad PD1 and the second cluster pad PD2 in the second direction DR2 in a plan view. In addition, the first extension bent portion ECP1 of the first routing line DRL1 and the second extension bent portion ECP2 of the second routing line DRL2 may be located in the area MPA between the first cluster pad PD1 and the second cluster pad PD2. For example, the first extension bent portion ECP1 of the first routing line DRL1 and the second extension bent portion ECP2 of the second routing line DRL2 may overlap the area MPA between the first cluster pad PD1 and the second cluster pad PD2 in the second direction DR2 in a plan view.

In the first routing line DRL1 and the second routing line DRL2 arranged adjacent to each other among the first routing lines DRL1 and the second routing lines DRL2, the front end bent portion SCP1 and the first rear end bent portion FCP1 of the first routing line DRL1 may be arranged to overlap the first cluster pad PD1 in the second direction DR2 in a plan view. In addition, the second front end bent portion SCP2 of the second routing line DRL2 may also be arranged to overlap the first cluster pad PD1 in the second direction DR2 in a plan view.

Referring to FIG. 10, the first routing lines DRL1 and the second routing lines DRL2 may be alternately arranged at different layers.

The first routing lines DRL1 may include a first-first routing line DRL1-1 and a first-second routing line DRL1-2, and the second routing lines DRL2 may include a second-first routing line DRL2-1 and a second-second routing line DRL2-2.

For example, the barrier layer BR, the buffer layer BF, and the thin film transistor layer TFTL may be sequentially arranged on the substrate SUB in the third direction DR3. For example, the first barrier layer BR1, the second barrier layer BR2, the first buffer layer BF1, the second buffer layer BF2, and the first gate insulating layer GTI1 may be arranged on the substrate SUB.

The first-first routing line DRL1-1 and the second-first routing line DRL2-1 may be located on the first gate insulating layer GTI1. The second gate insulating layer GTI2 may be located on the first-first routing line DRL1-1 and the second-first routing line DRL2-1. The first-second routing line DRL1-2 and the second-second routing line DRL2-2 may be located on the second gate insulating layer GTI2.

The first interlayer insulating layer ITL1, the third gate insulating layer GTI3, and the second interlayer insulating layer ITL2 may be located on the first-second routing line DRL1-2 and the second-second routing line DRL2-2. The first voltage line VDD1 may be located on the second interlayer insulating layer ITL2. The first planarization layer VA1 and the second planarization layer VA2 may be sequentially located on the first voltage line VDD1.

The first-first routing line DRL1-1 and the first-second routing line DRL1-2 of the first routing line DRL1 may be located at different layers. The first-first routing line DRL1-1 may be located on the first gate insulating layer GTI1 and located between the first gate insulating layer GTI1 and the second gate insulating layer GTI2. The first-second routing line DRL1-2 may be located on the second gate insulating layer GTI2 and located between the second gate insulating layer GTI2 and the first interlayer insulating layer ITL1. The first-first routing lines DRL1-1 and the first-second routing lines DRL1-2 may be alternately and repeatedly arranged with the second gate insulating layer GTI2 interposed therebetween.

The second-first routing line DRL2-1 and the second-second routing line DRL2-2 of the second routing line DRL2 may be located at different layers. The second-first routing line DRL2-1 may be located on the first gate insulating layer GTI1 and located between the first gate insulating layer GTI1 and the second gate insulating layer GTI2. The second-second routing line DRL2-2 may be located on the second gate insulating layer GTI2 and located between the second gate insulating layer GTI2 and the first interlayer insulating layer ITL1. The second-first routing lines DRL2-1 and the second-second routing lines DRL2-2 may be alternately and repeatedly arranged with the second gate insulating layer GTI2 interposed therebetween.

The first routing lines DRL1 and the second routing lines DRL2 may include routing lines located at different layers and alternately arranged, respectively. For example, the first-first routing line DRL1-1 located on the first gate insulating layer GTI1, the first-second routing line DRL1-2 located on the second gate insulating layer GTI2, the second-first routing line DRL2-1 located on the first gate insulating layer GTI1, and the second-second routing lines DRL2-2 located on the second gate insulating layer GTI2 may be sequentially and alternately in the first direction DR1 in a plan view.

As illustrated in FIGS. 10 and 11, the first routing lines DRL1 and the second routing lines DRL2 may be arranged to overlap the first power line VDD1 in the third direction DR3 (e.g., the thickness direction). As described above, the widths and the lengths of each of the first routing lines DRL1 and the second routing lines DRL2 may be the same as each other. An overlap area between the first routing line DRL1 and the first power line VDD1 and an overlap area between the second routing line DRL2 and the first power line VDD1 may be the same as each other. When the overlap areas between the first and second routing lines DRL1 and DRL2 and the first power line VDD1 are different from each other, a difference in capacitance value generated between the first and second routing lines DRL1 and DRL2 and the first power line VDD1 may occur, which may cause RC delay.

According to some embodiments, the RC delay may be relatively improved by making the widths and the lengths of each of the first routing lines DRL1 and the second routing lines DRL2 the same as each other to make capacitance values formed by the first and second routing lines DRL1 and DRL2 and the first power line VDD1 (or another line) the same as each other.

At least in the areas where each of the first routing lines DRL1 and the second routing lines DRL2 and the first power line VDD1 overlap each other, intervals (or pitches) between the respective routing lines DRL1 and DRL2 may be the same as each other. For example, an interval P1 between the first-first routing line DRL1-1 and the first-second routing line DRL1-2, an interval P2 between the first-second routing line DRL1-2 and the second-first routing line DRL2-1, and an interval P3 between the second-first routing line DRL2-1 and the second-second routing line DRL2-2 may be the same as each other.

Meanwhile, an interval between the first routing lines DRL1, an interval between the first routing line DRL1 and the second routing line DRL2, and an interval between the second routing lines DRL2 may be different from each other for each area.

Referring to FIGS. 7, 8, and 12, an interval between the first routing lines DRL1, for example, the first-first routing line DRL1-1 and the first-second routing line DRL1-2 may be different for each area. An interval PH1 between a first front end portion STP1 of the first-first routing line DRL1-1 and a first front end portion STP1 of the first-second routing line DRL1-2, an interval PH2 between a first middle portion MTP1 of the first-first routing line DRL1-1 and a first middle portion MTP1 of the first-second routing line DRL1-2, and an interval PH3 between a first rear end portion FTP1 of the first-first routing line DRL1-1 and a first rear end portion FTP1 of the first-second routing line DRL1-2 may be different from each other.

According to some embodiments, the interval PH1 between the first front end portion STP1 of the first-first routing line DRL1-1 and the first front end portion STP1 of the first-second routing line DRL1-2 may be greater than the interval PH2 between the first middle portion MTP1 of the first-first routing line DRL1-1 and the first middle portion MTP1 of the first-second routing line DRL1-2 and the interval PH3 between the first rear end portion FTP1 of the first-first routing line DRL1-1 and the first rear end portion FTP1 of the first-second routing line DRL1-2. The interval PH2 between the first middle portion MTP1 of the first-first routing line DRL1-1 and the first middle portion MTP1 of the first-second routing line DRL1-2 may be greater than the interval PH3 between the first rear end portion FTP1 of the first-first routing line DRL1-1 and the first rear end portion FTP1 of the first-second routing line DRL1-2. That is, the interval PH1 between the first front end portion STP1 of the first-first routing line DRL1-1 and the first front end portion STP1 of the first-second routing line DRL1-2 may be the greatest, and the interval PH3 between the first rear end portion FTP1 of the first-first routing line DRL1-1 and the first rear end portion FTP1 of the first-second routing line DRL1-2 may be the smallest.

However, embodiments according to the present disclosure are not limited thereto, and the interval PH1 between the first front end portion STP1 of the first-first routing line DRL1-1 and the first front end portion STP1 of the first-second routing line DRL1-2, the interval PH2 between the first middle portion MTP1 of the first-first routing line DRL1-1 and the first middle portion MTP1 of the first-second routing line DRL1-2, and the interval PH3 between the first rear end portion FTP1 of the first-first routing line DRL1-1 and the first rear end portion FTP1 of the first-second routing line DRL1-2 may also be the same as each other. In addition, embodiments according to the present disclosure are not limited thereto, and the interval PH1 between the first front end portion STP1 of the first-first routing line DRL1-1 and the first front end portion STP1 of the first-second routing line DRL1-2 may be greater than the interval PH2 between the first middle portion MTP1 of the first-first routing line DRL1-1 and the first middle portion MTP1 of the first-second routing line DRL1-2 and the interval PH3 between the first rear end portion FTP1 of the first-first routing line DRL1-1 and the first rear end portion FTP1 of the first-second routing line DRL1-2, and the interval PH2 between the first middle portion MTP1 of the first-first routing line DRL1-1 and the first middle portion MTP1 of the first-second routing line DRL1-2 and the interval PH3 between the first rear end portion FTP1 of the first-first routing line DRL1-1 and the first rear end portion FTP1 of the first-second routing line DRL1-2 may be the same as each other.

In addition, intervals between the first routing line DRL1 and the second routing line DRL2 adjacent to each other may be different from each other. For example, the first-second routing line DRL1-2 of the first routing line DRL1 and the second-first routing line DRL2-1 of the second routing line DRL2 may be arranged adjacent to each other. An interval PH4 between the first front end portion STP1 of the first-second routing line DRL1-2 and a second front end portion STP2 of the second-first routing line DRL2-1, an interval PH5 between the first middle portion MTP1 of the first-second routing line DRL1-2 and a second middle portion MTP2 of the second-first routing line DRL2-1, and an interval PH6 between the first rear end portion FTP1 of the first-second routing line DRL1-2 and a second rear end portion FTP2 of the second-first routing line DRL2-1 may be different from each other.

According to some embodiments, the interval PH4 between the first front end portion STP1 of the first-second routing line DRL1-2 and the second front end portion STP2 of the second-first routing line DRL2-1 may be greater than the interval PH5 between the first middle portion MTP1 of the first-second routing line DRL1-2 and the second middle portion MTP2 of the second-first routing line DRL2-1 and be smaller than the interval PH6 between the first rear end portion FTP1 of the first-second routing line DRL1-2 and the second rear end portion FTP2 of the second-first routing line DRL2-1. The interval PH5 between the first middle portion MTP1 of the first-second routing line DRL1-2 and the second middle portion MTP2 of the second-first routing line DRL2-1 may be smaller than the interval PH6 between the first rear end portion FTP1 of the first-second routing line DRL1-2 and the second rear end portion FTP2 of the second-first routing line DRL2-1. That is, the interval PH6 between the first rear end portion FTP1 of the first-second routing line DRL1-2 and the second rear end portion FTP2 of the second-first routing line DRL2-1 may be the greatest, and the interval PH5 between the first middle portion MTP1 of the first-second routing line DRL1-2 and the second middle portion MTP2 of the second-first routing line DRL2-1 may be the smallest.

However, embodiments according to the present disclosure are not limited thereto, and the interval PH4 between the first front end portion STP1 of the first-second routing line DRL1-2 and the second front end portion STP2 of the second-first routing line DRL2-1 may also be the same as the interval PH5 between the first middle portion MTP1 of the first-second routing line DRL1-2 and the second middle portion MTP2 of the second-first routing line DRL2-1.

In addition, an interval between the second routing lines DRL2, for example, the second-first routing line DRL2-1 and the second-second routing line DRL2-2, may be different for each area. An interval PH7 between the second front end portion STP2 of the second-first routing line DRL2-1 and a second front end portion STP2 of the second-second routing line DRL2-2, an interval PH8 between the second middle portion MTP2 of the second-first routing line DRL2-1 and a second middle portion MTP2 of the second-second routing line DRL2-2, and an interval PH9 between the second rear end portion FTP2 of the second-first routing line DRL2-1 and a second rear end portion FTP2 of the second-second routing line DRL2-2 may be different from each other.

According to some embodiments, the interval PH7 between the second front end portion STP2 of the second-first routing line DRL2-1 and the second front end portion STP2 of the second-second routing line DRL2-2 may be greater than the interval PH8 between the second middle portion MTP2 of the second-first routing line DRL2-1 and the second middle portion MTP2 of the second-second routing line DRL2-2 and the interval PH9 between the second rear end portion FTP2 of the second-first routing line DRL2-1 and the second rear end portion FTP2 of the second-second routing line DRL2-2. The interval PH8 between the second middle portion MTP2 of the second-first routing line DRL2-1 and the second middle portion MTP2 of the second-second routing line DRL2-2 may be greater than the interval PH9 between the second rear end portion FTP2 of the second-first routing line DRL2-1 and the second rear end portion FTP2 of the second-second routing line DRL2-2. That is, the interval PH7 between the second front end portion STP2 of the second-first routing line DRL2-1 and the second front end portion STP2 of the second-second routing line DRL2-2 may be the greatest, and the interval PH9 between the second rear end portion FTP2 of the second-first routing line DRL2-1 and the second rear end portion FTP2 of the second-second routing line DRL2-2 may be the smallest.

However, embodiments according to the present disclosure are not limited thereto, and the interval PH7 between the second front end portion STP2 of the second-first routing line DRL2-1 and the second front end portion STP2 of the second-second routing line DRL2-2, the interval PH8 between the second middle portion MTP2 of the second-first routing line DRL2-1 and the second middle portion MTP2 of the second-second routing line DRL2-2, and the interval PH9 between the second rear end portion FTP2 of the second-first routing line DRL2-1 and the second rear end portion FTP2 of the second-second routing line DRL2-2 may also be the same as each other. In addition, embodiments according to the present disclosure are not limited thereto, and the interval PH7 between the second front end portion STP2 of the second-first routing line DRL2-1 and the second front end portion STP2 of the second-second routing line DRL2-2 may be greater than the interval PH8 between the second middle portion MTP2 of the second-first routing line DRL2-1 and the second middle portion MTP2 of the second-second routing line DRL2-2 and the interval PH9 between the second rear end portion FTP2 of the second-first routing line DRL2-1 and the second rear end portion FTP2 of the second-second routing line DRL2-2, and the interval PH8 between the second middle portion MTP2 of the second-first routing line DRL2-1 and the second middle portion MTP2 of the second-second routing line DRL2-2 and the interval PH9 between the second rear end portion FTP2 of the second-first routing line DRL2-1 and the second rear end portion FTP2 of the second-second routing line DRL2-2 may be the same as each other.

As described above, the display device according to some embodiments may prevent or reduce the RC delay by making the line resistances of the routing lines the same as each other by adjusting extension shapes of the routing lines in order to make the widths and the lengths of the routing lines the same as each other. Accordingly, it may be possible to relatively improve display quality by relatively improving a luminance difference of the display device.

The display device according to one embodiment of the present disclosure can be applied to various electronic devices. The electronic device according to the one embodiment of the present disclosure includes the display device described above, and may further include modules or devices having additional functions in addition to the display device.

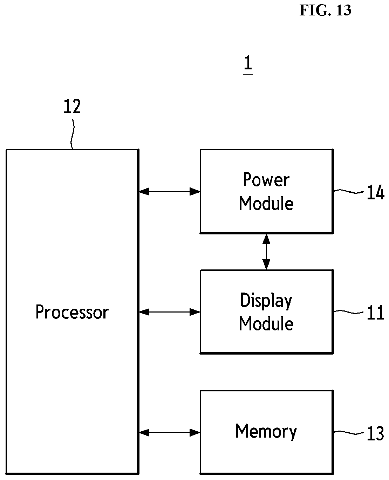

FIG. 13 is a block diagram of an electronic device according to one embodiment of the present disclosure.

Referring to FIG. 13, the electronic device 1 according to one embodiment of the present disclosure may include a display module 11, a processor 12, a memory 13, and a power module 14.

The processor 12 may include at least one of a central processing unit (CPU), an application processor (AP), a graphic processing unit (GPU), a communication processor (CP), an image signal processor (ISP), and a controller.

The memory 15 may store data information necessary for the operation of the processor 12 or the display module 11. When the processor 12 executes an application stored in the memory 15, an image data signal and/or an input control signal is transmitted to the display module 11, and the display module 11 can process the received signal and output image information through a display screen.

The power module 14 may include a power supply module such as, for example a power adapter or a battery, and a power conversion module that converts the power supplied by the power supply module to generate power necessary for the operation of the electronic device 1.

At least one of the components of the electronic device 11 according to the one embodiment of the present disclosure may be included in the display device 10 according to the embodiments of the present disclosure. In addition, some modules of the individual modules functionally included in one module may be included in the display device 10, and other modules may be provided separately from the display device 10. For example, the display device 10 may include the display module 11, and the processor 12, the memory 13, and the power module 14 may be provided in the form of other devices within the electronic device 11 other than the display device 10.

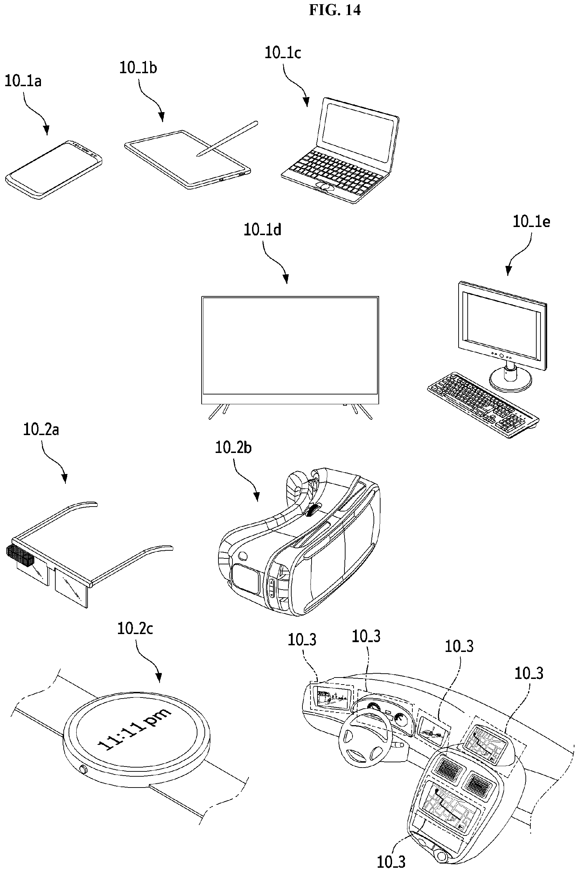

FIG. 14 is a schematic diagram of an electronic device according to various embodiments of the present disclosure.

Referring to FIG. 14, various electronic devices to which display devices 10 according to embodiments of the present disclosure are applied may include not only image display electronic devices such as a smart phone 10_1a, a tablet PC (personal computer) 10_1b, a laptop 10_1c, a TV 10_1d, and a desk monitor 10_1e, but also wearable electronic devices including display modules such as, for example smart glasses 10_2a, a head mounted display 10_2b, and a smart watch 10_2c, and vehicle electronic devices 10_3 including display modules such as a CID (Center Information Display) and a room mirror display arranged on a dashboard, center fascia, and dashboard of an automobile.

In concluding the detailed description, those skilled in the art will appreciate that many variations and modifications can be made to the disclosed embodiments without substantially departing from the principles of the present invention. Therefore, the disclosed embodiments of the invention are used in a generic and descriptive sense only and not for purposes of limitation.

## Claims

1. A display device (10, 100) comprising:
a substrate (SUB) including a display area (DA) and a non-display area (NDA) a pad area (PA) in the non-display area of the substrate;
a first cluster pad (PD1) and a second cluster pad (PD1) in the pad area; and
routing lines (DRL1, DRL2) on the substrate and electrically connected from the display area to the first cluster pad and the second cluster pad,
wherein the routing lines (DRL1, DRL2)include a first routing line (DRL1) extending to the first cluster pad and a second routing line (DRL2) extending to the second cluster pad,
the first routing line (DRL1) and the second routing line (DRL2) are adjacent to each other,
the first routing line (DRL1) includes a first middle portion extending in a second direction crossing a first direction that is a horizontal direction, and the second routing line (DRL1) includes a second middle portion adjacent to and parallel to the first middle portion, and
the first middle portion and the second middle portion are between the first cluster pad and the second cluster pad.

2. The display device (10, 100) of claim 1, wherein the first routing line (DRL1) includes a first front end portion (STP1) extending from the display area, a first connection portion (DATP1) bent and extending from the first front end portion, a first extension portion (EAP1) bent and extending from a first middle portion (MTP1), and a first rear end portion (FTP1) bent from the first extension portion (EAP1) and extending to the first cluster pad, and
the first middle portion (MTP1) is bent and extends from the first connection portion (DATP1).

3. The display device (10, 100) of claim 2, wherein the first front end portion, the first middle portion (MTP1), and the first rear end portion (FTP1) extend in the second direction and are parallel to each other.

4. The display device (10, 100) of any of the preceding claims , further comprising a power line (VDD1) on the non-display area, extending in the first direction, and overlapping the routing lines (DRL1, DRL2).

5. The display device (10, 100) of claim 4, wherein the first front end portion (STP1) and the first middle portion (MTP1) do not overlap the power line (VDD1), and the first connection portion (DATP1) overlaps the power line.

6. The display device (10, 100) of any of claims 2 to 5, wherein the second routing line (DRL1) includes a second front end portion (STP1) extending from the display area, a second connection portion (DATP2) bent and extending from the second front end portion, a second extension portion (EAP2) bent and extending from a second middle portion (MTP2), and a second rear end portion (FTP2) bent from the second extension portion (EAP2) and extending to the second cluster pad, and the second middle portion (MTP2) is bent and extends from the second connection portion (DATP2).

7. The display device (10, 100) of claim 6, wherein the second front end portion, the second middle portion (MTP2), and the second rear end portion (FTP1) extend in the second direction and are parallel to each other, and
the first front end portion (STP1) and the second front end portion (STP2), the first middle portion (MTP1) and the second middle portion (MTP2), and the first rear end portion (FTP1) and the second rear end portion (FTP2) are parallel to each other, respectively.

8. The display device (10, 100) of claim 4, 6 or 7,
wherein the second front end portion (STP2) and the second middle portion (MTP2) do not overlap the power line, and the second connection portion (DATP2) overlaps the power line (VDD1).

9. The display device (10, 100) of any of claims 6 to 8, wherein the first routing line (DRL1) further includes a first front end bent portion between the first front end portion (STP1) and the first connection portion (DATP1), a first middle bent portion between the first connection portion (DATP1) and the first middle portion (MTP1), a first extension bent portion between the first middle portion (MTP1) and the first extension portion, and a first rear end bent portion between the first extension portion (EAP1) and the first rear end portion (FTP1).

10. The display device (10, 100) of any of claims 6 to 9, wherein the second routing line (DRL2) further includes a second front end bent portion between the second front end portion (STP2) and the second connection portion (DATP2), a second middle bent portion between the second connection portion (DATP2) and the second middle portion (MTP2), a second extension bent portion between the second middle portion (MTP2) and the second extension portion, and a second rear end bent portion between the second extension portion (EAP1) and the second rear end portion (FTP2).

11. The display device (10, 100) of any of claims 6 to 10, wherein an interval between the first front end portion (STP1) and the second front end portion (STP2) is greater than an interval between the first middle portion (MTP1) and the second middle portion (MTP2), and
an interval between the first rear end portion (FTP1) and the second rear end portion (FTP2) is greater than the interval between the first front end portion (STP1) and the second front end portion (STP2).

12. The display device (10, 100) of claim 2, wherein the first routing line (DRL1) includes a plurality of first routing lines (DRL1-1, DRL1-2) adjacent to each other,
wherein an interval between the first front end portions of each of the plurality of first routing lines (DRL1-1, DRL1-2)adjacent to each other is greater than an interval between the first middle portions (MTP1) of the plurality of first routing lines (DRL1-1, DRL1-2) adjacent to each other, and
the interval between the first middle portions of the plurality first routing lines (DRL1-1, DRL1-2) adjacent to each other is greater than an interval between the plurality of first rear end portions (DRL1-1, DRL1-2) of the first routing lines adjacent to each other.

13. The display device (10, 100) of claim 6, wherein the second routing line (DRL2) includes a plurality of second routing lines (DRL2-1, DRL2-2) adjacent to each other,
wherein an interval between the second front end portions of the plurality of second routing lines (DRL2-1, DRL2-2) adjacent to each other is greater than an interval between the second middle portions of the plurality of second routing lines (DRL2-1, DRL2-2) adjacent to each other, and
the interval between the second middle portions of the plurality of second routing lines (DRL2-1, DRL2-2) adjacent to each other is greater than an interval between the plurality of second rear end portions of the second routing lines (DRL2-1, DRL2-2) adjacent to each other.

14. The display device (10, 100) of any of claims 1 to 13, wherein width and length of each of the routing lines (DRL1, DRL2) are equal to each other, respectively.

15. An electronic device (1), comprising:
a display device (10, 100) of any of the preceding claims, the display device being configured to provide an image;
a processor (12) configured to provide an image data signal to the display device (10, 100);
a memory (13, 15) configured to store a data information for operation; and
a power module configured to generate power.
